# EUROPEAN PATENT SPECIFICATION

(11) **EP 3 493 192 B1**
(45) Date of publication and mention of the grant of the patent: **10.05.2023**
(21) Application number: 17765063.7
(22) Date of filing: 17.02.2017
(51) Int. Cl.: G09G 3/3258, G09G 3/3266

(54) **PIXEL CIRCUIT, DISPLAY PANEL, AND DRIVING METHOD**
PIXELSCHALTUNG, ANZEIGETAFEL UND ANSTEUERUNGSVERFAHREN
CIRCUIT DE PIXELS, PANNEAU D'AFFICHAGE, ET PROCÉDÉ DE COMMANDE

(30) Priority: 26.07.2016 CN 201610596931
(43) Date of publication of application: 05.06.2019
(73) Proprietor: BOE Technology Group Co., Ltd., Beijing 100015 (CN); Chengdu BOE Optoelectronics Technology Co., Ltd., Chengdu, Sichuan 611731 (CN)
(72) Inventor: WU, Yuan, Beijing 100176 (CN); NIE, Jun, Beijing 100176 (CN); WANG, Zheng, Beijing 100176 (CN)
(74) Representative: Klunker IP Patentanwälte PartG mbB
(86) International application number: PCT/CN2017/073897
(87) International publication number: WO 2018/018879

(56) References cited:
- CN-A- 103 474 024
- CN-A- 104 751 804
- CN-A- 105 074 808
- CN-A- 105 096 837
- CN-A- 105 427 807
- CN-A- 106 023 898
- US-A1- 2015 364 083
- US-A1- 2016 210 906

## Description

### TECHNICAL FIELD

The present invention relates to a pixel circuit, a display panel and a driving method.

### BACKGROUND

Organic light-emitting diode (OLED) display panels have wide development prospective in the display field due to the characteristics of autoluminescence, high contrast, low thickness, wide viewing angle, rapid response speed, capability of being applied to flexible panels, wide service temperature range, simple production, etc.

Due to the above characteristics, an OLED display panel may be applied to a device with display function such as a mobile phone, a display, a notebook computer, a digital camera, an instrument or the like.

US 2015364083 A1 dislcoses an OLED display that includes a display panel, a data driver, an emission control driver, a timing controller, a gate driver, an initialization driver, and a timing controller, wherein the emission control driver sequentially applies an emission control signal to emission control lines. The emission control signal determines a light emission period and a non-light emission period, the timing controller outputs a first start signal and a second start signal, the gate driver receives the first start signal from the timing controller, sequentially applies a gate initialization signal to gate initialization lines based on the first start signal and sequentially applies a scan signal to the scan lines and the initialization driver receives the second start signal and sequentially applys an OLED initialization signal to the OLED initialization lines.

### SUMMARY

It is an object of the present invention to provide a pixel circuit, a display panel comprising the pixel circuit, and a driving method thereof.

The object is achieved by the features of the respective independent claims. Further embodiments are defined in the corresponding dependent claims.

### BRIEF DESCRIPTION OF THE DRAWINGS

In order to clearly illustrate the technical solution of the embodiments of the disclosure, the drawings of the embodiments will be briefly described in the following; the described drawings are only related to some embodiments of the disclosure and thus are not limitative of the disclosure.
FIG. 1 is a first schematic diagram of a pixel circuit provided by an embodiment of the present disclosure;
FIG. 2 is a second schematic diagram of a pixel circuit provided by an embodiment of the present disclosure;
FIG. 3 is a drive timing diagram of the pixel circuit as illustrated in FIG. 2 provided by an embodiment of the present disclosure when a first OLED emits light independently;
FIG. 4A is a schematic diagram illustrating the conduction state in the pre-reset period when the pixel circuit as illustrated in FIG. 2 provided by an embodiment of the present disclosure is driven by the drive timing as illustrated in FIG. 3;
FIG. 4B is a schematic diagram illustrating the conduction state in the reset period when the pixel circuit as illustrated in FIG. 2 provided by an embodiment of the present disclosure is driven by the drive timing as illustrated in FIG. 3;
FIG. 4C is a schematic diagram illustrating the conduction state in the compensation period when the pixel circuit as illustrated in FIG. 2 provided by an embodiment of the present disclosure is driven by the drive timing as illustrated in FIG. 3;
FIG. 4D is a schematic diagram illustrating the conduction state in the initialization period when the pixel circuit as illustrated in FIG. 2 provided by an embodiment of the present disclosure is driven by the drive timing as illustrated in FIG. 3;
FIG. 4E is a schematic diagram illustrating the conduction state in the pre-emission period when the pixel circuit as illustrated in FIG. 2 provided by an embodiment of the present disclosure is driven by the drive timing as illustrated in FIG. 3;
FIG. 4F is a schematic diagram illustrating the conduction state in the emission period when the pixel circuit as illustrated in FIG. 2 provided by an embodiment of the present disclosure is driven by the drive timing as illustrated in FIG. 3;
FIG. 5 is a drive timing diagram of the pixel circuit as illustrated in FIG. 2 provided by an embodiment of the present disclosure when a first OLED, a second OLED and a third OLED emit light simultaneously;
FIG. 6A is a schematic diagram illustrating the conduction state in the pre-reset period when the pixel circuit as illustrated in FIG. 2 provided by an embodiment of the present disclosure is driven by the drive timing as illustrated in FIG. 5;
FIG. 6B is a schematic diagram illustrating the conduction state in the reset period when the pixel circuit as illustrated in FIG. 2 provided by an embodiment of the present disclosure is driven by the drive timing as illustrated in FIG. 5;
FIG. 6C is a schematic diagram illustrating the conduction state in the compensation period when the pixel circuit as illustrated in FIG. 2 provided by an embodiment of the present disclosure is driven by the drive timing as illustrated in FIG. 5;
FIG. 6D is a schematic diagram illustrating the conduction state in the initialization period when the pixel circuit as illustrated in FIG. 2 provided by an embodiment of the present disclosure is driven by the drive timing as illustrated in FIG. 5;
FIG. 6E is a schematic diagram illustrating the conduction state in the pre-emission period when the pixel circuit as illustrated in FIG. 2 provided by an embodiment of the present disclosure is driven by the drive timing as illustrated in FIG. 5;
FIG. 6F is a schematic diagram illustrating the conduction state in the emission period when the pixel circuit as illustrated in FIG. 2 provided by an embodiment of the present disclosure is driven by the drive timing as illustrated in FIG. 5;
FIG. 7 is a first schematic diagram of still another pixel circuit provided by an embodiment of the present disclosure;
FIG. 8 is a second schematic diagram of still another pixel circuit provided by an embodiment of the present disclosure;
FIG. 9 is a drive timing diagram of the pixel circuit as illustrated in FIG. 8 provided by an embodiment of the present disclosure;
FIG. 10A is a schematic diagram illustrating the conduction state in the pre-reset period when the pixel circuit as illustrated in FIG. 8 provided by an embodiment of the present disclosure is driven by the drive timing as illustrated in FIG. 9;
FIG. 10B is a schematic diagram illustrating the conduction state in the reset period when the pixel circuit as illustrated in FIG. 8 provided by an embodiment of the present disclosure is driven by the drive timing as illustrated in FIG. 9;
FIG. 10C is a schematic diagram illustrating the conduction state in the compensation period when the pixel circuit as illustrated in FIG. 8 provided by an embodiment of the present disclosure is driven by the drive timing as illustrated in FIG. 9;
FIG. 10D is a schematic diagram illustrating the conduction state in the initialization period when the pixel circuit as illustrated in FIG. 8 provided by an embodiment of the present disclosure is driven by the drive timing as illustrated in FIG. 9;
FIG. 10E is a schematic diagram illustrating the conduction state in the pre-emission period when the pixel circuit as illustrated in FIG. 8 provided by an embodiment of the present disclosure is driven by the drive timing as illustrated in FIG. 9;
FIG. 10F is a schematic diagram illustrating the conduction state in the emission period when the pixel circuit as illustrated in FIG. 8 provided by an embodiment of the present disclosure is driven by the drive timing as illustrated in FIG. 9;
FIG. 11 is a schematic diagram of a display panel provided by an embodiment of the present disclosure; and
FIG. 12 is a schematic diagram illustrating the drive timing in a driving method provided by an embodiment of the present disclosure when a first OLED, a fourth OLED emit light and a second OLED and a third OLED are switched off.

### DETAILED DESCRIPTION

Clear and complete description will be given below to the technical proposals of the embodiments of the present disclosure to provide more comprehensive description on the preferred embodiments of the present disclosure and a variety of characteristics and favorable details thereof, with reference to the accompanying drawings and non-limiting preferred embodiments shown in the accompanying drawings and described in detail in the following description. It should be noted that the characteristics shown in the figures are not drawn in scale. The present disclosure omits the description on the known materials, components and process techniques, thereby not obscuring the preferred embodiments of the present disclosure. The given examples are only intended to facilitate an understanding of the implementation of the preferred embodiments of the present disclosure, so that the preferred embodiments can be further implemented by those skilled in the art. Therefore, the examples should not be construed as the limitation of the scope of the embodiments of the present disclosure.

Unless otherwise specified, the technical terms or scientific terms used in the present disclosure shall have normal meanings understood by those skilled in the art. The words "first", "second" and the like used in the present disclosure do not indicate any sequence, number or importance and are only intended to distinguish different components. In addition, in the embodiments of the present disclosure, same or similar reference numerals indicate same or similar members.

An OLED display panel generally comprises a plurality of pixel units; each pixel unit includes a plurality of subpixels respectively comprising OLEDs capable of emitting light of different colors; and each OLED may be respectively driven by a pixel circuit. However, because the pixel circuit occupies a large area, the resolution of the display panel can be affected.

Embodiments of the present disclosure provide a pixel circuit, a display panel and a driving method, which not only can reduce the occupied area of the pixel circuit and improve the resolution of the display panel but also can perform initialization discharge on OLEDs, ensure the accuracy under a low gray scale and full black under the state of a full dark frame, and effectively improve the contrast of the entire display panel.

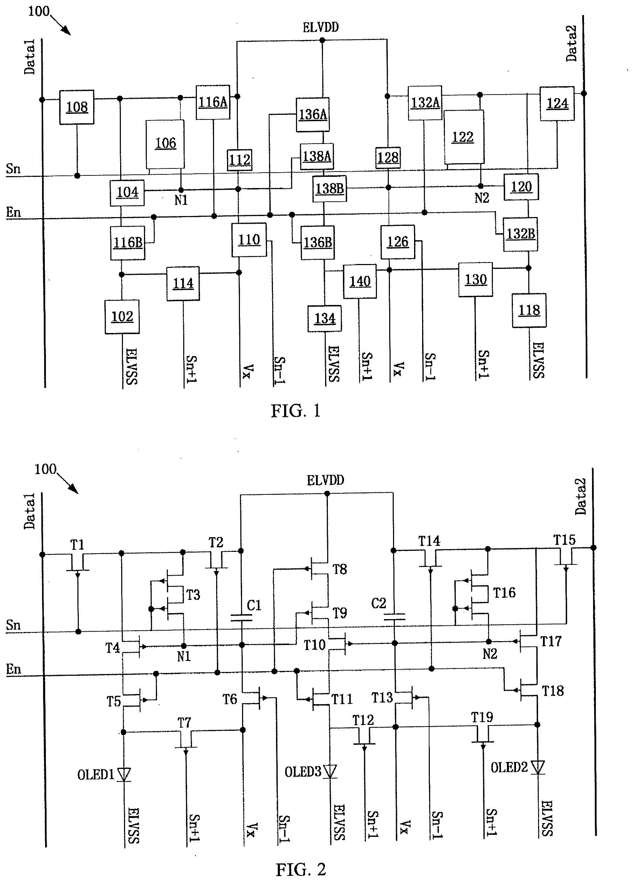

For instance, FIG. 1 is a first schematic diagram of a pixel circuit provided by an embodiment of the present disclosure. As illustrated in FIG. 1, the embodiment of the present disclosure provides a pixel circuit 100, which comprises: a first light-emitting circuit 102 configured to emit light in a working process; a first drive circuit 104 configured to drive the first light-emitting circuit 102; a first compensating circuit 106 configured to compensate the first drive circuit 104; a first data write circuit 108 configured to write data into the first drive circuit 104; a first reset circuit 110 configured to reset the first drive circuit 104; a first storage circuit 112 configured to store the driving voltage of the first drive circuit 104; a first initializing circuit 114 configured to initialize the first light-emitting circuit 102; a first light-emitting control circuit 116 configured to control the ON and OFF operations of the first light-emitting circuit 102, for instance, the first light-emitting control circuit 116 includes a first part 116A and a second part 116B; a second light-emitting circuit 118 configured to emit light in the working process; a second drive circuit 120 configured to drive the second light-emitting circuit 118; a second compensating circuit 122 configured to compensate the second drive circuit 120; a second data write circuit 124 configured to write data into the second drive circuit 120; a second reset circuit 126 configured to reset the second drive circuit 120; a second storage circuit 128 configured to store the driving voltage of the second drive circuit 120; a second initializing circuit 130 configured to initialize the second light-emitting circuit 118; a second light-emitting control circuit 132 configured to control the ON and OFF operations of the second light-emitting circuit 118, for instance, the second light-emitting control circuit 132 includes a first part 132A and a second part 132B; a third light-emitting circuit 134 configured to emit light in the working process; a third light-emitting control circuit 136 configured to control the ON and OFF operations of the third light-emitting circuit 134, for instance, the third light-emitting control circuit 136 includes a first part 136A and a second part 136B; a third drive circuit 138 configured to drive the third light-emitting circuit 134, for instance, the third drive circuit 138 includes a first part 138A and a second part 138B; a third initializing circuit 140 configured to initialize the third light-emitting circuit 134; a first power end ELVDD configured to provide a first luminous voltage Velvdd for the first light-emitting circuit 102, the second light-emitting circuit 118 and the third light-emitting circuit 134; a second power end ELVSS configured to provide a second luminous voltage Velvss for the first light-emitting circuit 102, the second light-emitting circuit 118 and the third light-emitting circuit 134; a third power end Vx configured to provide a reset voltage Vvx for the first reset circuit 110 and the second reset circuit 126; a first data signal end Data1 configured to provide a first data signal or a standby signal for the first data write circuit 108; a second data signal end Data2 configured to provide a second data signal or a standby signal for the second data write circuit 124; a first control end Sn-1 configured to provide a first control signal for controlling the ON and OFF operations of the first reset circuit 110 and the second reset circuit 126; a second control end Sn configured to provide a second control signal for controlling the ON and OFF operations of the first data write circuit 108, the first compensating circuit 106, the second data write circuit 124 and the second compensating circuit 122; a third control end Sn+1 configured to provide a third control signal for controlling the ON and OFF operations of the first initializing circuit 114, the second initializing circuit 130 and the third initializing circuit 140; and a fourth control end En configured to provide a fourth control signal for controlling the ON and OFF operations of the first light-emitting control circuit 116, the second light-emitting control circuit 132, and the third light-emitting control circuit 136.

For instance, FIG. 2 is a second schematic diagram of the pixel circuit provided by an embodiment of the present disclosure. FIG. 2 is a preferred embodiment of the pixel circuit as illustrated in FIG. 1. As illustrated in FIGS. 1 and 2, in the pixel circuit 100 provided by an embodiment of the present disclosure, the first data write circuit 108 includes a first transistor T1; the first light-emitting control circuit 116 includes a second transistor T2 and a fifth transistor T5, for instance, the first part 116A of the first light-emitting control circuit 116 includes the second transistor T2 and the second part 116B of the first light-emitting control circuit 116 includes the fifth transistor T5; the first compensating circuit 106 includes a third transistor T3; the first drive circuit 104 includes a fourth transistor T4; the first reset circuit 110 includes a sixth transistor T6; the first initializing circuit 114 includes a seventh transistor T7; the first storage circuit 112 includes a first storage capacitor C1; the first light-emitting circuit 102 includes a first organic light-emitting diode OLED1; the third light-emitting control circuit 136 includes an eighth transistor T8 and an eleventh transistor T11, for instance, the first part 136A of the third light-emitting control circuit 136 includes the eighth transistor T8 and the second part 136B of the third light-emitting control circuit 136 includes the eleventh transistor T11; the third drive circuit 138 includes a ninth transistor T9 and a tenth transistor T10, for instance, the first part 138A of the third drive circuit138 includes the ninth transistor T9 and the second part 138B of the third drive circuit 138 includes the tenth transistor T10; the third initializing circuit 140 includes a twelveth transistor T12; the second reset circuit 126 includes a thirteenth transistor T13; the second light-emitting control circuit 132 includes a fourteenth transistor T14 and an eighteenth transistor T18, for instance, the first part 132A of the second light-emitting control circuit 132 includes the fourteenth transistor T14 and the second part 132B of the second light-emitting control circuit 132 includes the eighteenth transistor T18; the second data write circuit 124 includes a fifteenth transistor T15; the second compensating circuit 122 includes a sixteenth transistor T16; the second drive circuit 120 includes a seventeenth transistor T17; the second initializing circuit 130 includes a ninteenth transistor T19; the second storage circuit 128 includes a second storage capacitor C2; the second light-emitting circuit 118 includes a second organic light-emitting diode OLED2; and the third light-emitting circuit 134 includes a third organic light-emitting diode OLED3.

For instance, as illustrated in FIG. 2, the third transistor T3 includes a first sub-transistor and a second sub-transistor; a source electrode of the first sub-transistor is taken as a source electrode of the third transistor T3; a drain electrode of the first sub-transistor is electrically connected with a source electrode of the second sub-transistor; a drain electrode of the second sub-transistor is taken as a drain electrode of the third transistor T3; and a gate electrode of the first sub-transistor and a gate electrode of the second sub-transistor are electrically connected with each other to act as a gate electrode of the third transistor T3 together. The sixteenth transistor T16 includes a third sub-transistor and a fourth sub-transistor; a source electrode of the third sub-transistor is taken as a source electrode of the sixteenth transistor T16; a drain electrode of the third sub-transistor is electrically connected with a source electrode of the fourth sub-transistor; a drain electrode of the fourth sub-transistor is taken as a drain electrode of the sixteenth transistor T16; and a gate electrode of the third sub-transistor and a gate electrode of the fourth sub-transistor are electrically connected with each other to act as a gate electrode of the sixteenth transistor T16 together. The configuragion of the third transistor T3 and the sixteenth transistor T16 can allow at least one of the first sub-transistor or the second sub-transistor to be in a saturation region and at least one of the third sub-transistor or the fourth sub-transistor to be in a saturation region. It should be noted that the embodiment of the present disclosure includes but not limited to the configuration of the third transistor T3 and the sixteenth transistor T16; the third transistor T3 may include one transistor only; and the sixteenth transistor T16 may also include one transistor only. Other transistors in the embodiment of the present disclosure may also be arranged with reference to the configuration of the third transistor T3 or the sixteenth transistor T16 according to actual demands, and similar modifications shall fall within the scope of protection of the present disclosure.

For instance, as illustrated in FIG. 2, in the pixel circuit 100 provided by an embodiment of the present disclosure, a source electrode of the first transistor T1 is electrically connected with the first data signal end Data1; a gate electrode of the first transistor T1 and a gate electrode of the third transistor T3 are electrically connected with the second control end Sn; a drain electrode of the first transistor T1, a drain electrode of the second transistor T2, a source electrode of the third transistor T3, and a source electrode of the fourth transistor T4 are electrically connected with each other; a gate electrode of the second transistor T2 and a gate electrode of the fifth transistor T5 are electrically connected with the fourth control end En; a source electrode of the second transistor T2 and a first end of the first storage capacitor C1 are electrically connected with the first power end ELVDD; a drain electrode of the third transistor T3 is electrically connected with a first node N1; a gate electrode of the fourth transistor T4 is electrically connected with the first node N1; a drain electrode of the fourth transistor T4 is electrically connected with a source electrode of the fifth transistor T5; a drain electrode of the fifth transistor T5 and a drain electrode of the seventh transistor T7 are electrically connected with a first end of the first organic light-emitting diode OLED1; a source electrode of the sixth transistor T6 and a source electrode of the seventh transistor T7 are electrically connected with the third power end Vx; a gate electrode of the sixth transistor T6 is electrically connected with the first control end Sn-1; a drain electrode of the sixth transistor T6 is electrically connected with the first node N1; a gate electrode of the seventh transistor T7 is electrically connected with the third control end Sn+1; a second end of the first storage capacitor C1 is electrically connected with the first node N1; a second end of the first organic light-emitting diode OLED1 is electrically connected with the second power end ELVSS; a source electrode of the eighth transistor T8 is electrically connected with the first power end ELVDD; a gate electrode of the eighth transistor T8 is electrically connected with the fourth control end En; a drain electrode of the eighth transistor T8 is electrically connected with a source electrode of the ninth transistor T9; a gate electrode of the ninth transistor T9 is electrically connected with the first node N1; a drain electrode of the ninth transistor T9 is electrically connected with a source electrode of the tenth transistor T10; a gate electrode of the tenth transistor T10 is electrically connected with a second node N2; a drain electrode of the tenth transistor T10 is electrically connected with a source electrode of the eleventh transistor T11; a gate electrode of the eleventh transistor T11 is electrically connected with the fourth control end En; a drain electrode of the eleventh transistor T11 and a first end of the third organic light-emitting diode OLED3 are electrically connected with a drain electrode of the twelveth transistor T12; a gate electrode of the twelveth transistor T12 is electrically connected with the third control end Sn+1; a source electrode of the twelveth transistor T12, a drain electrode of the thirteenth transistor T13 and a source electrode of the ninteenth transistor T19 are electrically connected with the third power end Vx; a source electrode of the thirteenth transistor T13 is electrically connected with the second node N2; a gate electrode of the thirteenth transistor T13 is electrically connected with the first control end Sn-1; a source electrode of the fourteenth transistor T14 and a first end of the second storage capacitor C2 are electrically connected with the first power end ELVDD; a gate electrode of the fourteenth transistor T14 and a gate electrode of the eighteenth transistor T18 are electrically connected with the fourth control end En; a drain electrode of the fourteenth transistor T14, a drain electrode of the fifteenth transistor T15, a source electrode of the sixteenth transistor T16, and a source electrode of the seventeenth transistor T17 are electrically connected with each other; a source electrode of the fifteenth transistor T15 is electrically connected with the second data signal end Data2; a gate electrode of the fifteenth transistor T15 and a gate electrode of the sixteenth transistor T16 are electrically connected with the second control end Sn; a drain electrode of the sixteenth transistor T16 is electrically connected with the second node N2; a gate electrode of the seventeenth transistor T17 is electrically connected with the second node N2; a drain electrode of the seventeenth transistor T17 is electrically connected with a source electrode of the eighteenth transistor T18; a drain electrode of the eighteenth transistor T18 and a drain electrode of the ninteenth transistor T19 are electrically connected with a first end of the second organic light-emitting diode OLED2; a gate electrode of the ninteenth transistor T19 is electrically connected with the third control end Sn+1; a second end of the second storage capacitor C2 is electrically connected with the second node N2; a second end of the second organic light-emitting diode OLED2 is electrically connected with the second power end ELVSS; and a second end of the third organic light-emitting diode OLED3 is electrically connected with the second power end ELVSS.

For instance, in the pixel circuit provided by an embodiment of the present disclosure, the first transistor T1, the second transistor T2, the third transistor T3, the fourth transistor T4, the fifth transistor T5, the sixth transistor T6, the seventh transistor T7, the eighth transistor T8, the ninth transistor T9, the tenth transistor T10, the eleventh transistor T11, the twelveth transistor T12, the thirteenth transistor T13, the fourteenth transistor T14, the fifteenth transistor T15, the sixteenth transistor T16, the seventeenth transistor T17, the eighteenth transistor T18, and the ninteenth transistor T19 are all TFTs.

For instance, in the pixel circuit provided by an embodiment of the present disclosure, the first transistor T1, the second transistor T2, the third transistor T3, the fourth transistor T4, the fifth transistor T5, the sixth transistor T6, the seventh transistor T7, the eighth transistor T8, the ninth transistor T9, the tenth transistor T10, the eleventh transistor T11, the twelveth transistor T12, the thirteenth transistor T13, the fourteenth transistor T14, the fifteenth transistor T15, the sixteenth transistor T16, the seventeenth transistor T17, the eighteenth transistor T18, and the ninteenth transistor T19 are all P-type transistors.

It should be noted that the transistors adopted in the embodiment of the present disclosure may all be TFTs or field-effect transistors (FETs) or other switching elements with the same characteristics. The source electrode and the drain electrode of a transistor adopted here may be symmetrical in structure, so the source electrode and the drain electrode of the transistor may have no difference in structure. In the embodiments of the present disclosure, in order to distinguish two electrodes of the transistor except the gate electrode, one electrode is directly described as the source electrode and the other electrode is directly described as the drain electrode, so the source electrodes and the drain electrodes of all the or some transistors in the embodiments of the present disclosure may be exchanged as required In addition, transistors may be divided into N-type transistors and P-type transistors according to the characteristics of the transistors. Description is given in the embodiment of the present disclosure by taking the case that the transistors are all P-type transistors as an example. The implementation that the embodiment of the present disclosure adopts N-type transistors can be easily conceived of by those skilled in the art without creative efforts on the basis of the description and instruction on the implementation of the P-type transistors in the present disclosure. Therefore, the implementations shall also fall within the scope of protection of the present disclosure.

For instance, in the pixel circuit 100 provided by an embodiment of the present disclosure, the first organic light-emitting diode OLED1 emits light of first color in the working process; the second organic light-emitting diode OLED2 emits light of second color in the working process; the third organic light-emitting diode OLED3 emits light of third color in the working process; and a mixed color of the light of the first color and the light of the second color is the third color.

For instance, in one example of the pixel circuit 100 provided by an embodiment of the present disclosure, the light of the first color is red light; the light of the second color is green light; and the light of the third color is yellow light. A mixed color of red and green is yellow.

For instance, the pixel circuit 100 simultaneously controls the first organic light-emitting diode OLED1, the second organic light-emitting diode OLED2 and the third organic light-emitting diode OLED3, reduces the number of the pixel circuits as a whole, reduces the area occupied by the pixel circuit, and improves the resolution of the display panel.

For instance, when the pixel circuit 100 operates, the first organic light-emitting diode OLED1 and the second organic light-emitting diode OLED2 can emit light independently, or the first organic light-emitting diode OLED1, the second organic light-emitting diode OLED2 and the third organic light-emitting diode OLED3 may emit light simultaneously.

For instance, according to different display frames, the brightness of the third organic light-emitting diode OLED3 may be adapted to replace the combined brightness of the first organic light-emitting diode OLED1 and the second organic light-emitting diode OLED2. In a display frame in which the third organic light-emitting diode OLED3 is required to emit light, the first organic light-emitting diode OLED1, the second organic light-emitting diode OLED2 and the third organic light-emitting diode OLED3 emit light simultaneously, which is equivalent to increase the area of luminescent materials of the first organic light-emitting diode OLED1 and the second organic light-emitting diode OLED2 and reduce the luminous brightness of the first organic light-emitting diode OLED1 and the second organic light-emitting diode OLED2. Thus, the aging of organic functional materials in the first organic light-emitting diode OLED1 and the second organic light-emitting diode OLED2 can be decelerated, and the service life of the first organic light-emitting diode OLED1 and the second organic light-emitting diode OLED2 can be prolonged.

For instance, in the pixel circuit 100 provided by an embodiment of the present disclosure, the threshold voltage of the fourth transistor T4 is equal to the threshold voltage of the ninth transistor T9, and the threshold voltage of the tenth transistor T10 is equal to the threshold voltage of the seventeenth transistor T17. Thus, when the first organic light-emitting diode OLED1, the second organic light-emitting diode OLED2 and the third organic light-emitting diode OLED3 emit light simultaneously, the luminous brightness of the third organic light-emitting diode OLED3 is the same as the brightness of the OLED with low brightness out of the first organic light-emitting diode OLED1 and the second organic light-emitting diode OLED2.

The embodiment of the present disclosure further provides a driving method of the pixel circuit as illustrated in FIG. 2. The driving method comprises: a reset period, a compensation period, an initialization period and an emission period. In the reset period, the first control end Sn-1 emits a valid signal; the second control end Sn outputs an invalid signal; the third control end Sn+1 outputs an invalid signal; the fourth control end En outputs an invalid signal; the first data signal end Data1 outputs a standby signal; and the second data signal Data2 outputs a standby signal. In the compensation period, the first control end Sn-1 emits an invalid signal; the second control end Sn outputs a valid signal; the third control end Sn+1 outputs an invalid signal; the fourth control end En outputs an invalid signal; the first data signal end Data1 outputs a first data signal, and the second data signal Data2 outputs a standby signal; alternatively, the first data signal end Data1 outputs a standby signal, and the second data signal Data2 outputs a second data signal; alternatively, the first data signal end Data1 outputs the first data signal, and the second data signal Data2 outputs the second data signal. In the initialization period, the first control end Sn-1 emits an invalid signal; the second control end Sn outputs an invalid signal; the third control end Sn+1 outputs a valid signal; the fourth control end En outputs an invalid signal; the first data signal end Data1 outputs a standby signal; and the second data signal Data2 outputs a standby signal. In the emission period, the first control end Sn-1 emits an invalid signal; the second control end Sn outputs an invalid signal; the third control end Sn+1 outputs an invalid signal; the fourth control end En outputs a valid signal; the first data signal end Data1 outputs a standby signal; and the second data signal Data2 outputs a standby signal.

For instance, the driving method provided by an embodiment of the present disclosure may further comprise: a pre-reset period and a pre-emission period. The pre-reset period is after the emission period and before the reset period, and the pre-emission period is after the initialization period and before the emission period. In the pre-reset period, the first control end Sn-1 emits an invalid signal; the second control end Sn outputs an invalid signal; the third control end Sn+1 outputs an invalid signal; the fourth control end En outputs an invalid signal; the first data signal end Data1 outputs a standby signal; and the second data signal Data2 outputs a standby signal. In the pre-emission period, the first control end Sn-1 emits an invalid signal; the second control end Sn outputs an invalid signal; the third control end Sn+1 outputs an invalid signal; the fourth control end En outputs an invalid signal; the first data signal end Data1 outputs a standby signal; and the second data signal Data2 outputs a standby signal.

For instance, in the driving method provided by an embodiment of the present disclosure, in the compensation period, when the first data signal Data1 outputs the first data signal and the second data signal end Data2 outputs the standby signal, the first light-emitting circuit 102 emits light independently, and the first data signal is configured to control the luminous brightness of the first light-emitting circuit 102; when the first data signal end Data1 outputs the standby signal and the second data signal end Data2 outputs the second data signal, the second light-emitting circuit 118 emits light independently, and the second data signal is configured to control the luminous brightness of the second light-emitting circuit 118; and when the first data signal end Data1 outputs the first data signal and the second data signal end Data2 outputs the second data signal, the first light-emitting circuit 102, the second light-emitting circuit 118 and the third light-emitting circuit 134 emit light simultaneously; the first data signal is configured to control the luminous brightness of the first light-emitting circuit 102; the second data signal is configured to control the luminous brightness of the second light-emitting circuit 118; and a smaller data signal in the first data signal and the second data signal is configured to control the luminous brightness of the third light-emitting circuit 134.

It should be noted that a valid signal in the embodiments of the present disclosure refers to a signal capable of switching on corresponding circuit or transistor; an invalid signal refers to a signal capable of switching off corresponding circuit or transistor; the first data signal or the second data signal refers to a signal including luminous brightness information of corresponding light-emitting circuit or OLED (for instance, a low level signal); and the standby signal refers to a signal capable of disabling the light emission of corresponding light-emitting circuit or OLED (for instance, a high level signal). For instance, as for the case the transistors are P-type transistors, the valid signal refers to a low level signal and the invalid signal refers to a high level signal. The specific voltage of the low level signal and the high level signal may be correspondingly set according to the properties of the transistors. Description will be given below in the embodiments of the present disclosure by taking the case that the transistors are all P-type transistors as an example.

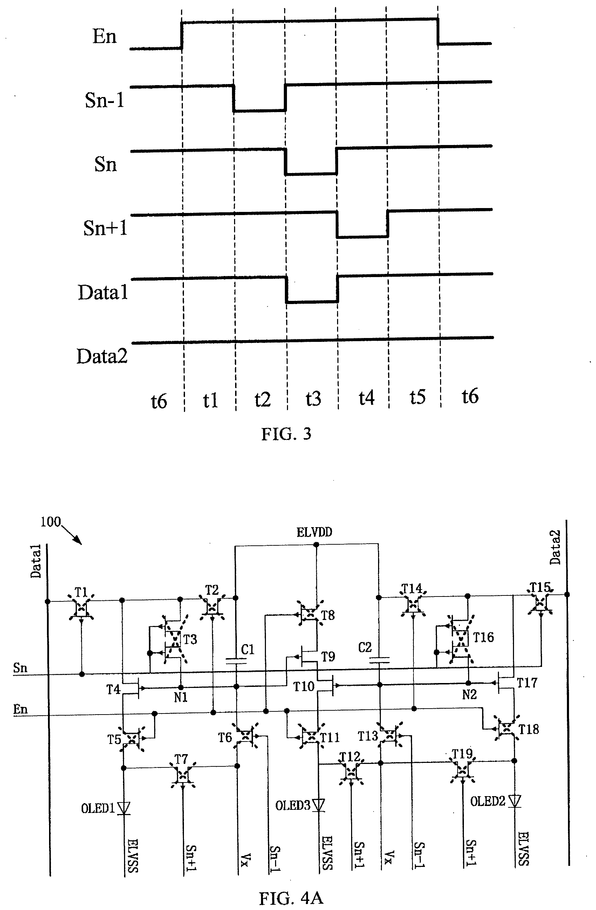

For instance, FIG. 3 is a drive timing diagram of the pixel circuit as illustrated in FIG. 2 provided by an embodiment of the present disclosure when the first OLED emits light independently. As illustrated in FIG. 3, the embodiment of the present disclosure provides a driving method of the pixel circuit as illustrated in FIG. 2, which comprises: a pre-reset period t1, a reset period t2, a compensation period t3, an initialization period t4, a pre-emission period t5, and an emission period t6.

For instance, in the pre-reset period t1, the first control end Sn-1 outputs a high level signal; the second control end Sn outputs a high level signal; the third control end Sn+1 outputs a high level signal; the fourth control end En outputs a high level signal; the first data signal end Data1 outputs a high level signal; and the second data signal end Data2 outputs a high level signal.

For instance, FIG. 4A is a schematic diagram illustrating the conduction state in the pre-reset period t1 when the pixel circuit as illustrated in FIG. 2 provided by an embodiment of the present disclosure is driven by the drive timing as illustrated in FIG. 3. In the pre-reset period t1, the first transistor T1, the second transistor T2, the third transistor T3, the fifth transistor T5, the sixth transistor T6, the seventh transistor T7, the eighth transistor T8, the eleventh transistor T11, the twelveth transistor T12, the thirteenth transistor T13, the fourteenth transistor T14, the fifteenth transistor T15, the sixteenth transistor T16, the eighteenth transistor T18 and the ninteenth transistor T19 are all in the off-states, and no electrical current path is formed in the pixel circuit; and the conduction states of the fourth transistor T4, the ninth transistor T9, the tenth transistor T10 and the seventeenth transistor T17 are relevant to the voltages of the first node N1 and the second node N2. For instance, the pre-reset period can provide a stable time period for the pixel circuit, so that the voltage and the current of various circuit elements can be kept in a stable state, and hence the circuit abnormality can be avoided.

For instance, in the reset period t2, the first control end Sn-1 outputs a low level signal; the second control end Sn outputs a high level signal; the third control end Sn+1 outputs a high level signal; the fourth control end En outputs a high level signal; the first data signal end Data1 outputs a high level signal; and the second data signal end Data2 outputs a high level signal.

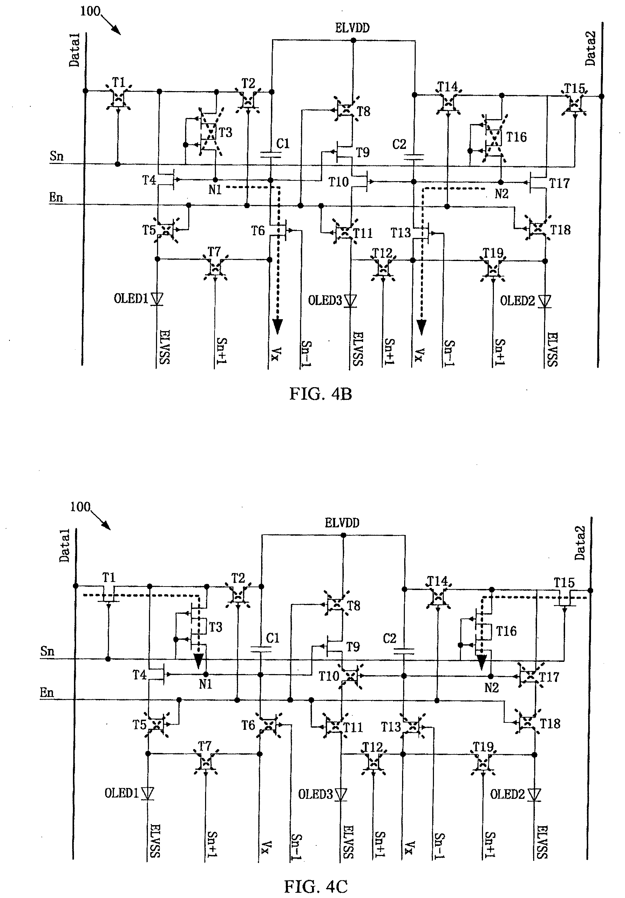

FIG. 4B is a schematic diagram illustrating the conduction state in the reset period t2 when the pixel circuit as illustrated in FIG. 2 provided by an embodiment of the present disclosure is driven by the drive timing as illustrated in FIG. 3. In the reset period t2, the first transistor T1, the second transistor T2, the third transistor T3, the fifth transistor T5, the seventh transistor T7, the eighth transistor T8, the eleventh transistor T11, the twelveth transistor T12, the fourteenth transistor T14, the fifteenth transistor T15, the sixteenth transistor T16, the eighteenth transistor T18, and the ninteenth transistor T19 are all in the off-states. Because the first control end Sn-1 outputs the low level signal, the sixth transistor T6 and the thirteenth transistor T13 are switched on; the voltages of the first node N1 and the second node N2 are the reset voltage Vvx provided by the third power end Vx; and the reset voltage Vvx is, for instance, a low level voltage capable of switching on the P-type transistor, or for instance, the reset voltage Vvx is a negative voltage. At this point, as the voltages of the first node N1 and the second node N2 are the low-level reset voltage Vvx, the fourth transistor T4, the ninth transistor T9, the tenth transistor T10 and the seventeenth transistor T17 are switched on, but no electrical current path is formed. Thus, the fourth transistor T4 and the ninth transistor T9 can be reset through the sixth transistor T6, and the tenth transistor T10 and the seventeenth transistor T17 can be reset through the thirteenth transistor T13. That is to say, the first reset circuit resets the first drive circuit; the second reset circuit resets the second drive circuit; and the first reset circuit and the second reset circuit reset the third drive circuit together. For instance, the voltage difference between the first node N1 and the first data signal Vdata1 can be increased after the reset period, so that the charging time for the first storage capacitor C1 can be reduced in the compensation period t3.

For instance, in the compensation period t3, the first control end Sn-1 outputs a high level signal; the second control end Sn outputs a low level signal; the third control end Sn+1 outputs a high level signal; the fourth control end En outputs a high level signal; the first data signal end Data1 outputs a first data signal Vdata1 (for instance, a low level signal); and the second data signal end Data2 outputs a high level signal.

FIG. 4C is a schematic diagram illustrating the conduction state when the pixel circuit as illustrated in FIG. 2 provided by an embodiment of the present disclosure is driven by the drive timing as illustrated in FIG. 3. In the compensation period t3, the second transistor T2, the fifth transistor T5, the sixth transistor T6, the seventh transistor T7, the eighth transistor T8, the tenth transistor T10, the eleventh transistor T11, the twelveth transistor T12, the thirteenth transistor T13, the fourteenth transistor T14, the seventeenth transistor T17, the eighteenth transistor T18, and the ninteenth transistor T19 are all in the off-states. As the second control end Sn outputs the low level signal, the first transistor T1, the third transistor T3, the fifteenth transistor T15, and the sixteenth transistor T16 are switched on; the first data signal Vdata1 outputted by the first data signal end Data1 is transmitted to the first node N1 through the first transistor T1 and the third transistor T3; after the first storage capacitor C1 is charged, the voltage of the first node N1 is Vdata1+Vth1 (Vth1 is the overall pressure drop of the first transistor T1 and the third transistor T3), namely the first data write circuit writes data into the first drive circuit, and the first compensating circuit compensates the first drive circuit; at this point, the fourth transistor T4 and the ninth transistor T9 are switched on, but no electrical current path is formed; the high level signal outputted by the second data signal end Data2 is transmitted to the second node N2 through the fifteenth transistor T15 and the sixteenth transistor T16; and the voltage of the second node N2 is in high level, so the tenth transistor T10 and the seventeenth transistor T17 are in the off-state.

For instance, in the initialization period t4, the first control end Sn-1 outputs a high level signal; the second control end Sn outputs a high level signal; the third control end Sn+1 outputs a low level signal; the fourth control end En outputs a high level signal; the first data signal end Data1 outputs a high level signal; and the second data signal end Data2 outputs a high level signal.

For instance, the initialization electrical discharge on the OLED(s) ensures the accuracy under a low gray scale and full black under a full dark frame, and effectively improves the contrast of the entire display panel.

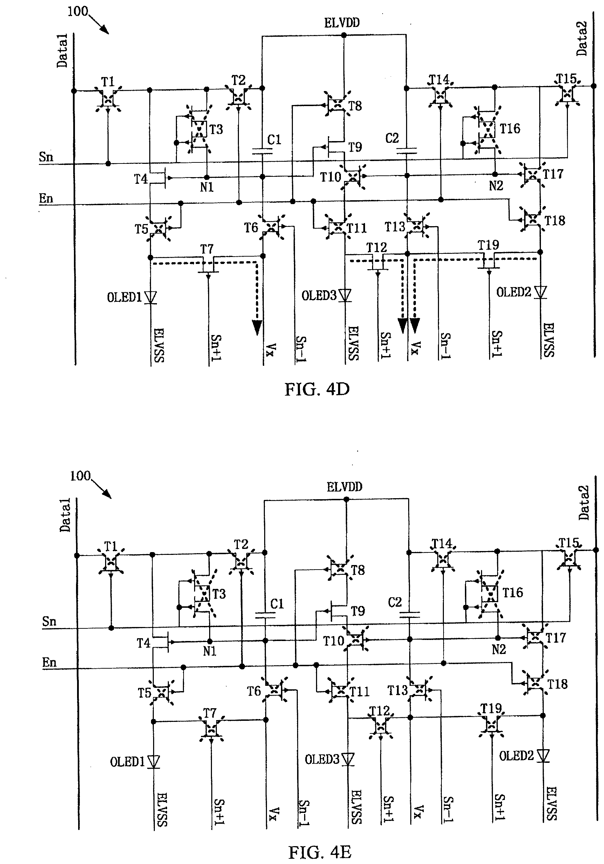

FIG. 4D is a schematic diagram illustrating the conduction state in the initialization period t4 when the pixel circuit as illustrated in FIG. 2 provided by an embodiment of the present disclosure is driven by the drive timing as illustrated in FIG. 3. In the initialization period t4, the first transistor T1, the second transistor T2, the third transistor T3, the fifth transistor T5, the sixth transistor T6, the eighth transistor T8, the tenth transistor T10, the eleventh transistor T11, the thirteenth transistor T13, the fourteenth transistor T14, the fifteenth transistor T15, the sixteenth transistor T16, the seventeenth transistor T17, and the eighteenth transistor T18 are all in the off-states. Because of the voltage storage function of the first storage capacitor C1, the fourth transistor T4 and the ninth transistor T9 are kept in the on-state the same state as that in the compensation period t3; as the third control end Sn+1 outputs the low level signal, the seventh transistor T7, the twelveth transistor T12 and the ninteenth transistor T19 are switched on; the reset voltage Vvx provided by the third power end Vx is transmitted to a first electrode (the first electrode is, for instance, an anode) of the first organic light-emitting diode OLED1 through the seventh transistor T7; the reset voltage Vvx provided by the third power end Vx is transmitted to a first electrode (the first electrode is, for instance, an anode) of the third organic light-emitting diode OLED3 through the twelveth transistor T12; and the reset voltage Vvx provided by the third power end Vx is transmitted to a first electrode (the first electrode is, for instance, an anode) of the second organic light-emitting diode OLED2 through the ninteenth transistor T19. That is to say, the first initializing circuit initializes the first light-emitting circuit; the second initializing circuit initializes the second light-emitting circuit; and the third initializing circuit initializes the third light-emitting circuit. For instance, the reset voltage Vvx is less than or equal to the second luminous voltage Velvss provided by the second power end ELVSS. Thus, the abnormal emission of the OLEDs can be prevented by initialization, and for instance, the slightly bright emission of the OLEDs in the non-luminous period can be avoided.

For instance, in the pre-emission period t5, the first control end Sn-1 outputs a high level signal; the second control end Sn outputs a high level signal; the third control end Sn+1 outputs a high level signal; the fourth control end En outputs a high level signal; the first data signal end Data1 outputs ahigh level signal; and the second data signal end Data2 outputs a high level signal.

FIG. 4E is a schematic diagram illustrating the conduction state in the pre-emission period t5 when the pixel circuit as illustrated in FIG. 2 provided by an embodiment of the present disclosure is driven by the drive timing as illustrated in FIG. 3. In the pre-emission period t5, the first transistor T1, the second transistor T2, the third transistor T3, the fifth transistor T5, the sixth transistor T6, the seventh transistor T7, the eighth transistor T8, the tenth transistor T10, the eleventh transistor T11, the twelveth transistor T12, the thirteenth transistor T13, the fourteenth transistor T14, the fifteenth transistor T15, the sixteenth transistor T16, the seventeenth transistor T17, the eighteenth transistor T18, and the ninteenth transistor T19 are all in the off-states, and no electrical current path is formed in the pixel circuit. Because of the voltage storage function of the first storage capacitor C1, the fourth transistor T4 and the ninth transistor T9 are kept in the on-state the same as that in the initialization period t4. For instance, the pre-emission period can provide a stable time period for the pixel circuit, so that the voltage and the current of various circuit elements can be kept in the stable state, and hence the circuit abnormality can be avoided.

For instance, in the emission period t6, the first control end Sn-1 outputs a high level signal; the second control end Sn outputs a high level signal; the third control end Sn+1 outputs a high level signal; the fourth control end En outputs a low level signal; the first data signal end Data1 outputs a high level signal; and the second data signal end Data2 outputs a high level signal.

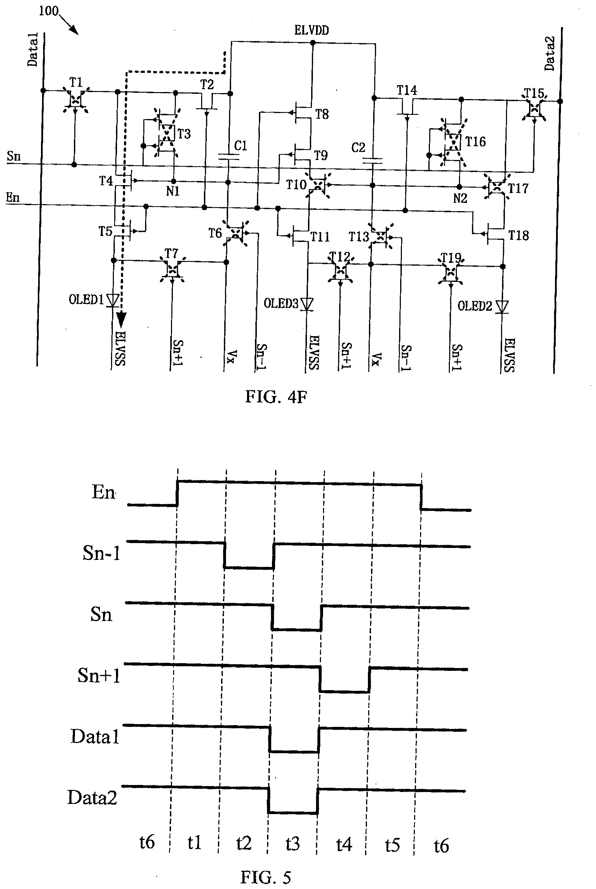

FIG. 4F is a schematic diagram illustrating the conduction state in the emission period t6 when the pixel circuit as illustrated in FIG. 2 provided by an embodiment of the present disclosure is driven by the drive timing as illustrated in FIG. 3. In the emission period t6, the first transistor T1, the third transistor T3, the sixth transistor T6, the seventh transistor T7, the tenth transistor T10, the twelveth transistor T12, the thirteenth transistor T13, the fifteenth transistor T15, the sixteenth transistor T16, the seventeenth transistor T17 and the ninteenth transistor T19 are all in the off-states. Because of the voltage storage function of the first storage capacitor C1, the fourth transistor T4 and the ninth transistor T9 are kept in the on-state the same as that in the pre-emission period t5. As the fourth control end En outputs the low level signal, the second transistor T2, the fifth transistor T5, the eighth transistor T8, the eleventh transistor T11, the fourteenth transistor T14 and the eighteenth transistor T18 are in the on-states; an electrical current path is formed by the first power end ELVDD, the second transistor T2, the fourth transistor T4, the fifth transistor T5, the first organic light-emitting diode OLED1 and the second power end ELVSS; and the first organic light-emitting diode OLED1 is driven by the fourth transistor T4 to emit light under the action of the first luminous voltage Velvdd provided by the first power end ELVDD and the second luminous voltage Velvss provided by the second power end ELVSS. That is to say, the first light-emitting control circuit controls the operation of the first light-emitting circuit; the first power end provides the first luminous voltage for the first light-emitting circuit; the second power end provides the second luminous voltage for the first light-emitting circuit; the first drive circuit drives the first light-emitting circuit; and the first light-emitting circuit emits light in the working process.

It should be noted that the driving method of the pixel circuit as illustrated in FIG. 2 may only comprise the reset period t2, the compensation period t3, the initialization period t4, and the emission period t6 and does not comprise the pre-reset period t1 and the pre-emission period t5, or comprises one of the pre-reset period t1 and the pre-emission period t5. No limitation will be given here.

For instance, the case that the second OLED emits light independently is similar to the case that the first OLED emits light independently. No further description will be given here.

FIG. 5 is a drive timing diagram of the pixel circuit as illustrated in FIG. 2 provided by an embodiment of the present disclosure when the first OLED, the second OLED and the third OLED emit light simultaneously. As illustrated in FIG. 5, the embodiment of the present disclosure provides a driving method of the pixel circuit as illustrated in FIG. 2, which comprises: a pre-reset period t1, a reset period t2, a compensation period t3, an initialization period t4, a pre-emission period t5 and an emission period t6.

For instance, in the pre-reset period t1, the first control end Sn-1 outputs a high level signal; the second control end Sn outputs a high level signal; the third control end Sn+1 outputs a high level signal; the fourth control end En outputs a high level signal; the first data signal end Data1 outputs a high level signal; and the second data signal end Data2 outputs a high level signal.

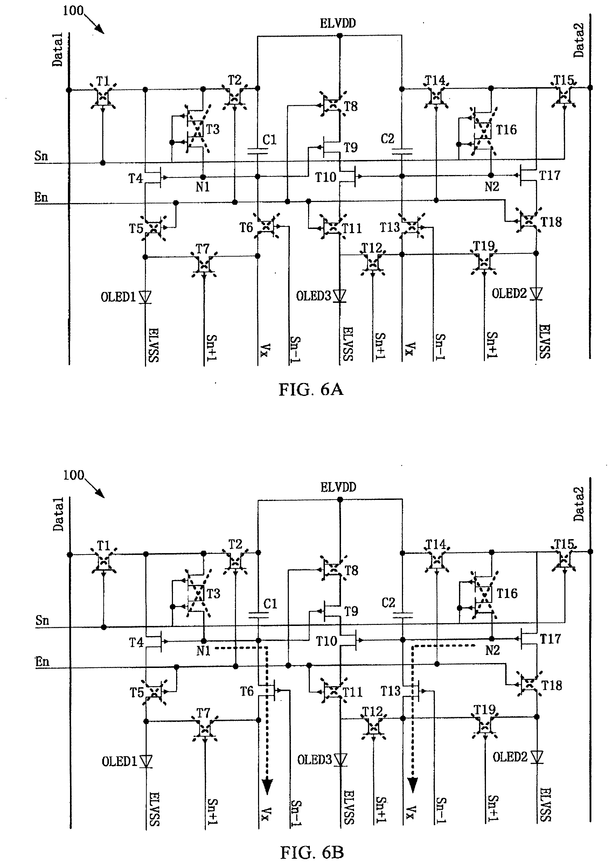

FIG. 6A is a schematic diagram illustrating the conduction state in the pre-reset period when the pixel circuit as illustrated in FIG. 2 provided by an embodiment of the present disclosure is driven by the drive timing as illustrated in FIG. 5. In the pre-reset period t1, the first transistor T1, the second transistor T2, the third transistor T3, the fifth transistor T5, the sixth transistor T6, the seventh transistor T7, the eighth transistor T8, the eleventh transistor T11, the twelveth transistor T12, the thirteenth transistor T13, the fourteenth transistor T14, the fifteenth transistor T15, the sixteenth transistor T16, the eighteenth transistor T18, and the ninteenth transistor T19 are all in the off-states, and no electrical current path is formed in the pixel circuit; and the conduction state of the fourth transistor T4, the ninth transistor T9, the tenth transistor T10 and the seventeenth transistor T17 is relevant to the voltages of the first node N1 and the second node N2. For instance, the pre-reset period can provide a stable time period for the pixel circuit, so that the voltage and the current of various circuit elements can be kept in a stable state, and hence the circuit abnormality can be avoided.

For instance, in the reset period t2, the first control end Sn-1 outputs a low level signal; the second control end Sn outputs a high level signal; the third control end Sn+1 outputs a high level signal; the fourth control end En outputs a high level signal; the first data signal end Data1 outputs a high level signal; and the second data signal end Data2 outputs a high level signal.

FIG. 6B is a schematic diagram illustrating the conduction state in the reset period when the pixel circuit as illustrated in FIG. 2 provided by an embodiment of the present disclosure is driven by the drive timing as illustrated in FIG. 5. In the reset period t2, the first transistor T1, the second transistor T2, the third transistor T3, the fifth transistor T5, the seventh transistor T7, the eighth transistor T8, the eleventh transistor T11, the twelveth transistor T12, the fourteenth transistor T14, the fifteenth transistor T15, the sixteenth transistor T16, the eighteenth transistor T18, and the ninteenth transistor T19 are all in the off-states. As the first control end Sn-1 outputs the low level signal, the sixth transistor T6 and the thirteenth transistor T13 are switched on; the voltages of the first node N1 and the second node N2 is the reset voltage Vvx provided by the third power end Vx; the reset voltage Vvx is, for instance, a low level voltage capable of switching on the P-type transistor, or for instance, the reset voltage Vvx is a negative voltage; and at this point, as the voltages of the first node N1 and the second node N2 are the low-level reset voltage Vvx, the fourth transistor T4, the ninth transistor T9, the tenth transistor T10, and the seventeenth transistor T17 are switched on, but no electrical current path is formed. Thus, the fourth transistor T4 and the ninth transistor T9 can be reset through the sixth transistor T6, and the tenth transistor T10 and the seventeenth transistor T17 can be reset through the thirteenth transistor T13. That is to say, the first reset circuit resets the first drive circuit; the second reset circuit resets the second drive circuit; and the first reset circuit and the second reset circuit reset the third drive circuit together. For instance, after the reset period, the voltage difference between the first node N1 and the first data signal Vdata1 can be increased, and the voltage difference between the second node N2 and the second data signal Vdata2 can be increased, so that the charging time of the first storage capacitor C1 and the second storage capacitor C2 can be reduced in the compensation period t3.

For instance, in the compensation period t3, the first control end Sn-1 outputs a high level signal; the second control end Sn outputs a low level signal; the third control end Sn+1 outputs a high level signal; the fourth control end En outputs a high level signal; the first data signal end Data1 outputs a first data signal Vdata1 (e.g., a low level signal); and the second data signal end Data2 outputs a second data signal Vdata2 (e.g., a low level signal).

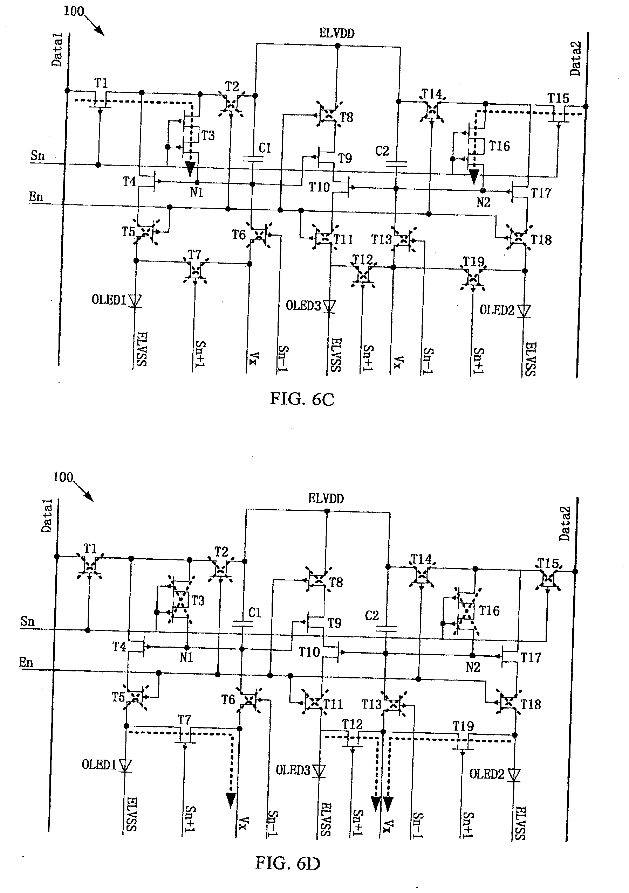

FIG. 6C is a schematic diagram illustrating the conduction state in the compensation period when the pixel circuit as illustrated in FIG. 2 provided by an embodiment of the present disclosure is driven by the drive timing as illustrated in FIG. 5. In the compensation period t3, the second transistor T2, the fifth transistor T5, the sixth transistor T6, the seventh transistor T7, the eighth transistor T8, the tenth transistor T10, the eleventh transistor T11, the twelveth transistor T12, the thirteenth transistor T13, the fourteenth transistor T14, the seventeenth transistor T17, the eighteenth transistor T18, and the ninteenth transistor T19 are all in the off-states. As the second control end Sn outputs the low level signal, the first transistor T1, the third transistor T3, the fifteenth transistor T15 and the sixteenth transistor T16 are switched on; the first data signal Vdata1 outputted by the first data signal end Data1 is transmitted to the first node N1 through the first transistor T1 and the third transistor T3; after the first storage capacitor C1 is charged, the voltage of the first node N1 is Vdata1+Vth1 (Vth1 is the overall pressure drop of the first transistor T1 and the third transistor T3), that is, the first data write circuit writes data into the first drive circuit, and the first compensating circuit compensates the first drive circuit; at this point, the fourth transistor T4 and the ninth transistor T9 are switched on, but no electrical current path is formed; the second data signal Vdata2 outputted by the second data signal end Data2 is transmitted to the second node N2 through the fifteenth transistor T15 and the sixteenth transistor T16; after the second storage capacitor C2 is charged, the voltage of the second node N2 is Vdata2+Vth2 (Vth2 is the overall pressure drop of the fifteenth transistor T15 and the sixteenth transistor T16), that is, the second data write circuit writes data into the second drive circuit, and the second compensating circuit compensates the second drive circuit; and at this point, the tenth transistor T10 and the seventeenth transistor T17 are switched on, but no electrical current path is formed.

For instance, in the initialization period t4, the first control end Sn-1 outputs a high level signal; the second control end Sn outputs a high level signal; the third control end Sn+1 outputs a low level signal; the fourth control end En outputs a high level signal; the first data signal end Data1 outputs a high level signal; and the second data signal end Data2 outputs a high level signal.

FIG. 6D is a schematic diagram illustrating the conduction state in the initialization period when the pixel circuit as illustrated in FIG. 2 provided by an embodiment of the present disclosure is driven by the drive timing as illustrated in FIG. 5. In the initialization period t4, the first transistor T1, the second transistor T2, the third transistor T3, the fifth transistor T5, the sixth transistor T6, the eighth transistor T8, the tenth transistor T10, the eleventh transistor T11, the thirteenth transistor T13, the fourteenth transistor T14, the fifteenth transistor T15, the sixteenth transistor T16, the seventeenth transistor T17 and the eighteenth transistor T18 are all in the off-states. Because of the voltage storage function of the first storage capacitor C1, the fourth transistor T4 and the ninth transistor T9 are kept in the on-state the same as that in the compensation period t3. Because of the voltage storage function of the second storage capacitor C2, the tenth transistor T10 and the seventeenth transistor T17 are kept in the on-state the same as that in the compensation period t3. As the third control end Sn+1 outputs the low level signal, the seventh transistor T7, the twelveth transistor T12 and the ninteenth transistor T19 are switched on; the reset voltage Vvx provided by the third power end Vx is transmitted to a first electrode (the first electrode is, for instance, an anode) of the first organic light-emitting diode OLED1 through the seventh transistor T7; the reset voltage Vvx provided by the third power end Vx is transmitted to a first electrode (the first electrode is, for instance, an anode) of the third organic light-emitting diode OLED3 through the twelveth transistor T12; and the reset voltage Vvx provided by the third power end Vx is transmitted to a first electrode (the first electrode is, for instance, an anode) of the second organic light-emitting diode OLED2 through the ninteenth transistor T19. That is to say, the first initializing circuit initializes the first light-emitting circuit; the second initializing circuit initializes the second light-emitting circuit; and the third initializing circuit initializes the third light-emitting circuit For instance, the reset voltage Vvx is less than or equal to the second luminous voltage Velvss provided by the second power end ELVSS. Thus, the abnormal emission of the OLED can be prevented by initialization, and for instance, the slightly bright emission of the OLED in the non-luminous period can be avoided.

For instance, in the pre-emission period t5, the first control end Sn-1 outputs a high level signal; the second control end Sn outputs a high level signal; the third control end Sn+1 outputs a high level signal; the fourth control end En outputs a high level signal; the first data signal end Data1 outputs a high level signal; and the second data signal end Data2 outputs a high level signal.

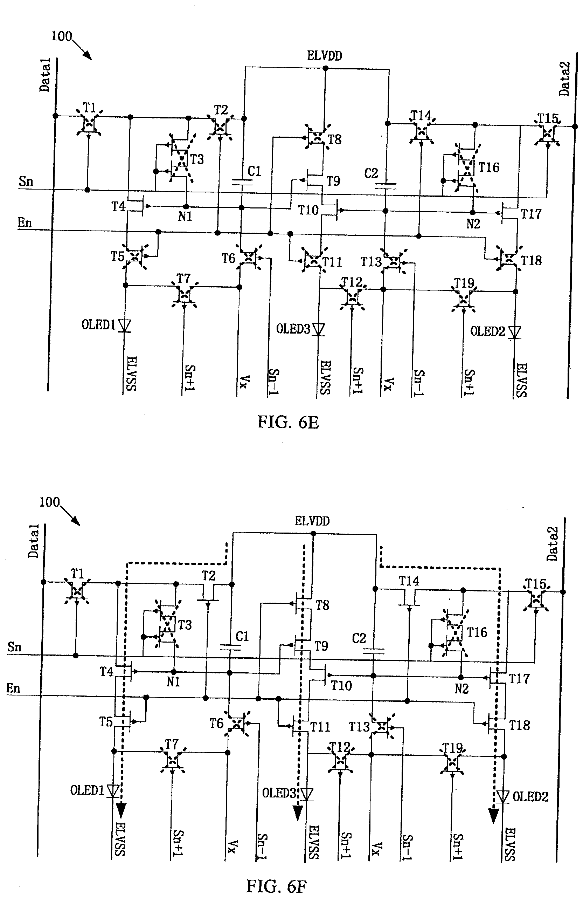

FIG. 6E is a schematic diagram illustrating the conduction state in the pre-emission period when the pixel circuit as illustrated in FIG. 2 provided by an embodiment of the present disclosure is driven by the drive timing as illustrated in FIG. 5. In the pre-emission period t5, the first transistor T1, the second transistor T2, the third transistor T3, the fifth transistor T5, the sixth transistor T6, the seventh transistor T7, the eighth transistor T8, the eleventh transistor T11, the twelveth transistor T12, the thirteenth transistor T13, the fourteenth transistor T14, the fifteenth transistor T15, the sixteenth transistor T16, the eighteenth transistor T18, and the ninteenth transistor T19 are all in the off-states, and no electrical current path is formed in the pixel circuit. Because of the voltage storage function of the first storage capacitor C1, the fourth transistor T4 and the ninth transistor T9 are kept in the on-state the same as that in the initialization period t4. Because of the voltage storage function of the second storage capacitor C2, the tenth transistor T10 and the seventeenth transistor T17 are kept in the on-state the same as that in the compensation period t4. For instance, the pre-emission period can provide a stable time period for the pixel circuit, so that the voltage and the current of various circuit elements can be kept in a stable state, and hence the circuit abnormality can be avoided.

For instance, in the emission period t6, the first control end Sn-1 outputs a high level signal; the second control end Sn outputs a high level signal; the third control end Sn+1 outputs a high level signal; the fourth control end En outputs a low level signal; the first data signal end Data1 outputs a high level signal; and the second data signal end Data2 outputs a high level signal.

FIG. 6F is a schematic diagram illustrating the conduction state in the emission period when the pixel circuit as illustrated in FIG. 2 provided by an embodiment of the present disclosure is driven by the drive timing as illustrated in FIG. 5. In the emission period t6, the first transistor T1, the third transistor T3, the sixth transistor T6, the seventh transistor T7, the twelveth transistor T12, the thirteenth transistor T13, the fifteenth transistor T15, the sixteenth transistor T16, and the ninteenth transistor T19 are all in the off-states. Because of the voltage storage function of the first storage capacitor C1, the fourth transistor T4 and the ninth transistor T9 are kept in the on-state the same as that in the pre-emission period t5. Because of the voltage storage function of the second storage capacitor C2, the tenth transistor T10 and the seventeenth transistor T17 are kept in the on-state the same as that in the compensation period t5. As the fourth control end En outputs the low level signal, the second transistor T2, the fifth transistor T5, the eighth transistor T8, the eleventh transistor T11, the fourteenth transistor T14 and the eighteenth transistor T18 are in the on-states. An electrical current path is formed by the first power end ELVDD, the second transistor T2, the fourth transistor T4, the fifth transistor T5, the first organic light-emitting diode OLED1 and the second power end ELVSS; an electrical current path is formed by the first power end ELVDD, the eighth transistor T8, the ninth transistor T9, the tenth transistor T10, the eleventh transistor T11, the third organic light-emitting diode OLED3 and the second power end ELVSS; and an electrical current path is formed by the first power end ELVDD, the fourteenth transistor T14, the seventeenth transistor T17, the eighteenth transistor T18, the second organic light-emitting diode OLED2 and the second power end ELVSS. The first organic light-emitting diode OLED1 is driven by the fourth transistor T4 to emit light under the action of the first luminous voltage Velvdd provided by the first power end ELVDD and the second luminous voltage Velvss provided by the second power end ELVSS; the second organic light-emitting diode OLED2 is driven by the seventeenth transistor T17 to emit light under the action of the first luminous voltage Velvdd provided by the first power end ELVDD and the second luminous voltage Velvss provided by the second power end ELVSS; and the third organic light-emitting diode OLED3 is driven by the ninth transistor T9 and the tenth transistor T10 to emit light under the action of the first luminous voltage Velvdd provided by the first power end ELVDD and the second luminous voltage Velvss provided by the second power end ELVSS. That is to say, the first light-emitting control circuit controls the operation of the first light-emitting circuit; the second light-emitting control circuit controls the operation of the second light-emitting circuit; the third light-emitting control circuit controls the operation of the third light-emitting circuit; the first power end provides the first luminous voltage for the first light-emitting circuit, the second light-emitting circuit and the third light-emitting circuit; the second power end provides the second luminous voltage for the first light-emitting circuit, the second light-emitting circuit and the third light-emitting circuit; the first drive circuit drives the first light-emitting circuit; the second drive circuit drives the second light-emitting circuit; the third drive circuit drives the third light-emitting circuit; and the first light-emitting circuit, the second light-emitting circuit and the third light-emitting circuit emit light in the working process.

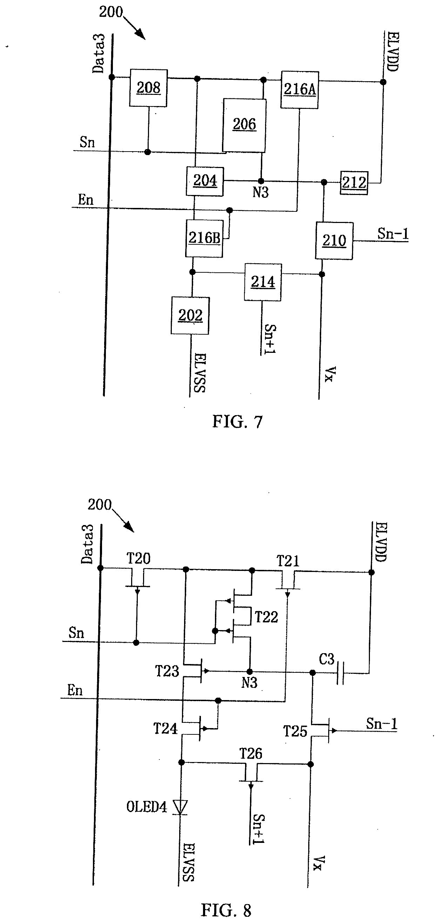

For instance, FIG. 7 is a first schematic diagram of still another pixel circuit provided by an embodiment of the present disclosure. As illustrated in FIG. 7, the embodiment of the present disclosure further provides a pixel circuit 200, which comprises: a fourth light-emitting circuit 202 configured to emit light in the working process; a fourth drive circuit 204 configured to drive the fourth light-emitting circuit 202; a third compensating circuit 206 configured to compensate the fourth drive circuit 204; a third data write circuit 208 configured to write data into the fourth drive circuit 204; a third reset circuit 210 configured to reset the fourth drive circuit 204; a third storage circuit 212 configured to store the driving voltage of the fourth drive circuit 204; a fourth initializing circuit 214 configured to initialize the fourth light-emitting circuit 202; a fourth light-emitting control circuit 216 configured to control the ON and OFF operations of the fourth light-emitting circuit 202; a first power end ELVDD configured to provide a first luminous voltage Velvdd for the fourth light-emitting circuit 202; a second power end ELVSS configured to provide a second luminous voltage Velvss for the fourth light-emitting circuit 202; a third power end Vx configured to provide a reset voltage Vvx for the third reset circuit 210; a third data signal end Data3 configured to provide a third data signal or a standby signal for the third data write circuit 208; a first control end Sn-1 configured to provide a first control signal for controlling the ON and OFF operations of the third reset circuit 210; a second control end Sn configured to provide a second control signal for controlling the ON and OFF operations of the third data write circuit 208 and the third compensating circuit 206; a third control end Sn+1 configured to provide a third control signal for controlling the ON and OFF operations of the fourth initializing circuit 214; and a fourth control end En configured to provide a fourth control signal for controlling the ON and OFF operations of the fourth light-emitting control circuit 216.

For instance, FIG. 8 is a second schematic diagram of still another pixel circuit provided by an embodiment of the present disclosure. FIG. 8 is a preferred embodiment of the pixel circuit as illustrated in FIG. 7. As illustrated in FIGS. 7 and 8, in the pixel circuit 200 provided by an embodiment of the present disclosure, the third data write circuit 208 includes a twentieth transistor T20; the fourth light-emitting control circuit 216 includes a twenty-first transistor T21 and a twenty-fourth transistor T24; the third compensating circuit 206 includes a twenty-second transistor T22; the fourth drive circuit 204 includes a twenty-third transistor T23; the third reset circuit 210 includes a twenty-fifth transistor T25; the fourth initializing circuit 214 includes a twenty-sixth transistor T26; the third storage circuit 212 includes a third storage capacitor C3; and the fourth light-emitting circuit 202 includes a fourth organic light-emitting diode OLED4.

For instance, as illustrated in FIG. 8, the twenty-second transistor T22 includes a fifth sub-transistor and a sixth sub-transistor; a source electrode of the fifth sub-transistor is taken as a source electrode of the twenty-second transistor T22; a drain electrode of the fifth sub-transistor is electrically connected with a source electrode of the sixth sub-transistor; a drain electrode of the sixth sub-transistor is taken as a drain electrode of the twenty-second transistor T22; and a gate electrode of the fifth sub-transistor and a gate electrode of the sixth sub-transistor are electrically connected with each other to act as a gate electrode of the twenty-second transistor T22 together. It should be noted that the embodiment of the present disclosure includes but not limited to the configuration of the twenty-second transistor, and the twenty-second transistor T22 may also include one transistor only.

For instance, as illustrated in FIG. 8, in the pixel circuit 200 provided by an embodiment of the present disclosure, a source electrode of the twentieth transistor T20 is electrically connected with the third data signal end Data3; a gate electrode of the twentieth transistor T20 and a gate electrode of the twenty-second transistor T22 are electrically connected with the second control end Sn; a drain electrode of the twentyth transistor T20, a drain electrode of the twenty-first transistor T21, a source electrode of the twenty-second transistor T22, and a source electrode of the twenty-third transistor T23 are electrically connected with each other; a gate electrode of the twenty-first transistor T21 and a gate electrode of the twenty-fourth transistor T24 are electrically connected with the fourth control end En; a source electrode of the twenty-first transistor T21 and a first end of the third storage capacitor C3 are electrically connected with the first power end ELVDD; a drain electrode of the twenty-second transistor T22 is electrically connected with a third node N3; a gate electrode of the twenty-third transistor T23 is electrically connected with the third node N3; a drain electrode of the twenty-third transistor T23 is electrically connected with a source electrode of the twenty-fourth transistor T24; a drain electrode of the twenty-fourth transistor T24 and a drain electrode of the twenty-sixth transistor T26 are electrically connected with a first end of the fourth organic light-emitting diode OLED4; a source electrode of the twenty-fifth transistor T25 and a source electrode of the twenty-sixth transistor T26 are electrically connected with the third power end Vx; a gate electrode of the twenty-fifth transistor T25 is electrically connected with the first control end Sn-1; a drain electrode of the twenty-fifth transistor T25 is electrically connected with the third node N3; a gate electrode of the twenty-sixth transistor T26 is electrically connected with the third control end Sn+1; a second end of the third storage capacitor C3 is electrically connected with the third node N3; and a second end of the fourth organic light-emitting diode OLED4 is electrically connected with the second power end ELVSS.

For instance, in the pixel circuit provided by an embodiment of the present disclosure, the twentieth transistor T20, the twenty-first transistor T21, the twenty-second transistor T22, the twenty-third transistor T23, the twenty-fourth transistor T24, the twenty-fifth transistor T25 and the twenty-sixth transistor T26 are all TFTs.

For instance, in the pixel circuit provided by an embodiment of the present disclosure, the twentieth transistor T20, the twenty-first transistor T21, the twenty-second transistor T22, the twenty-third transistor T23, the twenty-fourth transistor T24, the twenty-fifth transistor T25 and the twenty-sixth transistor T26 are all P-type transistors.

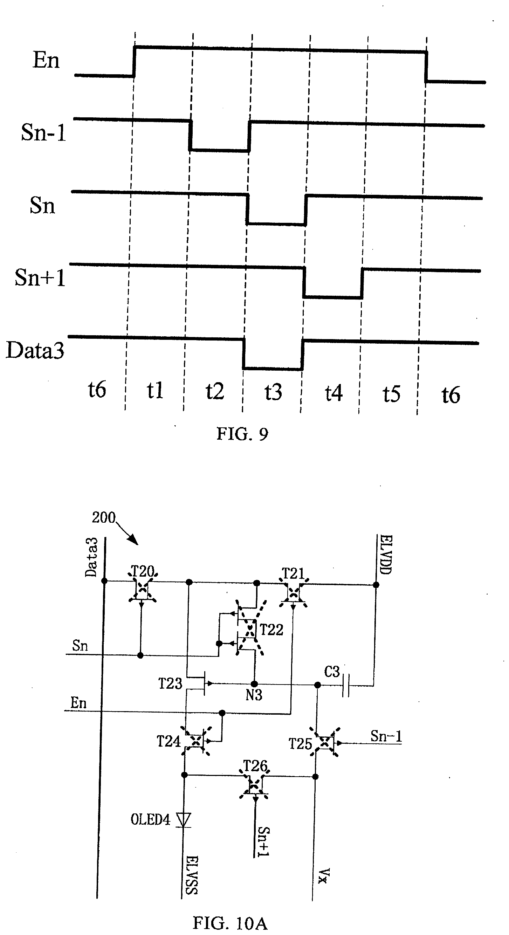

For instance, FIG. 9 is a drive timing diagram of the pixel circuit as illustrated in FIG. 8 provided by an embodiment of the present disclosure. The embodiment of the present disclosure further provides a driving method of the pixel circuit as illustrated in FIG. 8, which comprises: a pre-reset period t1, a reset period 52, a compensation period t3, an initialization period t4, a pre-emission period t5, and an emission period t6.

For instance, in the pre-reset period t1, the first control end Sn-1 outputs a high level signal; the second control end Sn outputs a high level signal; the third control end Sn+1 outputs a high level signal; the fourth control end En outputs a high level signal; and the third data signal end Data3 outputs a high level signal.

For instance, FIG. 10A is a schematic diagram illustrating the conduction state in the pre-reset period t1 when the pixel circuit as illustrated in FIG. 8 provided by an embodiment of the present disclosure is driven by the drive timing as illustrated in FIG. 9. In the pre-reset period t1, the twentieth transistor T20, the twenty-first transistor T21, the twenty-second transistor T22, the twenty-fourth transistor T24, the twenty-fifth transistor T25 and the twenty-sixth transistor T26 are all in the off-states, and no electrical current path is formed in the pixel circuit; and the conduction state of the twenty-third transistor T23 is relevant to the voltage of the third node N3. For instance, the pre-reset period can provide a stable time period for the pixel circuit, so that the voltage and the current of various circuit elements can be kept in a stable state, and hence the circuit abnormality can be avoided.

For instance, in the reset period t2, the first control end Sn-1 outputs a low level signal; the second control end Sn outputs a high level signal; the third control end Sn+1 outputs a high level signal; the fourth control end En outputs a high level signal; and the third data signal end Data3 outputs a high level signal.

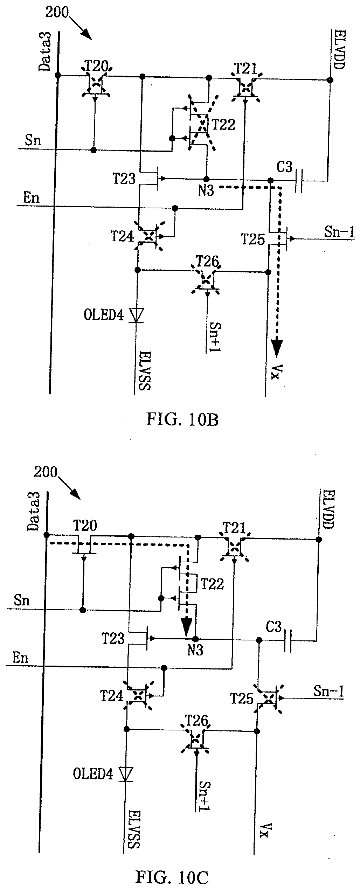

FIG. 10B is a schematic diagram illustrating the conduction state in the reset period t2 when the pixel circuit as illustrated in FIG. 8 provided by an embodiment of the present disclosure is driven by the drive timing as illustrated in FIG. 9. In the reset period t2, the twentieth transistor T20, the twenty-first transistor T21, the twenty-second transistor T22, the twenty-fourth transistor T24 and the twenty-sixth transistor T26 are all in the off-states. As the first control end Sn-1 outputs the low level signal, the twenty-fifth transistor T25 is switched on; the voltage of the third node N3 is the reset voltage Vvx provided by the third power end Vx; the reset voltage Vvx is, for instance, a low level voltage capable of switching on the P-type transistor, or for instance, the reset voltage Vvx is a negative voltage; and at this point, as the voltage of the third node N3 is the low-level reset voltage Vvx, the twenty-third transistor T23 is switched on, but no electrical current path is formed. Thus, the twenty-third transistor T23 is reset through the twenty-fifth transistor T25, namely the third reset circuit resets the fourth drive circuit. For instance, the voltage difference between the third node N3 and the third data signal Vdata3 can be increased after the reset period, so that the charging time of the third storage capacitor C3 can be reduced in the compensation period t3.

For instance, in the compensation period t3, the first control end Sn-1 outputs a high level signal; the second control end Sn outputs a low level signal; the third control end Sn+1 outputs a high level signal; the fourth control end En outputs a high level signal; and the third data signal end Data3 outputs a third data signal Vdata3 (e.g., a low level signal).

FIG. 10C is a schematic diagram illustrating the conduction state in the compensation period t3 when the pixel circuit as illustrated in FIG. 8 provided by an embodiment is driven by the drive timing as illustrated in FIG. 9. In the compensation period t3, the twenty-first transistor T21, the twenty-fourth transistor T24, the twenty-fifth transistor T25 and the twenty-sixth transistor T26 are all in the off-states. As the second control end Sn outputs the low level signal, the twentieth transistor T20 and the twenty-second transistor T22 are switched on; the third data signal Vdata3 outputted by the third data signal end Data3 is transmitted to the third node N3 through the twentieth transistor T20 and the twenty-second transistor T22; after the third storage capacitor C3 is charged, the voltage of the third node N3 is Vdata3+Vth3 (Vth3 is the overall pressure drop of the twentieth transistor T20 and the twenty-second transistor T22), that is, the third data write circuit writes data into the fourth drive circuit, and the third compensating circuit compensates the fourth drive circuit; and at this point, the twenty-third transistor T23 is switched on, but no electrical current path is formed.

For instance, in the initialization period t4, the first control end Sn-1 outputs a high level signal; the second control end Sn outputs a high level signal; the third control end Sn+1 outputs a low level signal; the fourth control end En outputs a high level signal; and the third data signal end Data3 outputs a high level signal.

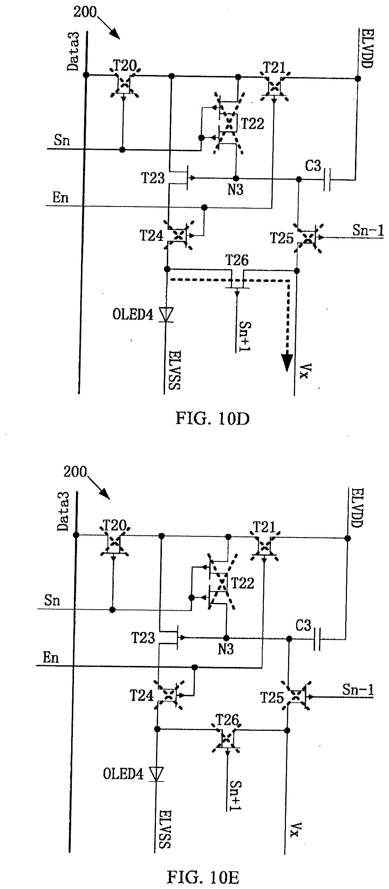

FIG. 10D is a schematic diagram illustrating the conduction state in the initialization period t4 when the pixel circuit as illustrated in FIG. 8 provided by an embodiment of the present disclosure is driven by the drive timing as illustrated in FIG. 9. In the initialization period t4, the twentieth transistor T20, the twenty-first transistor T21, the twenty-second transistor T22, the twenty-fourth transistor T24 and the twenty-fifth transistor T25 are all in the off-states. Because of the voltage storage function of the third storage capacitor C3, the twenty-third transistor T23 is kept in the on-state the same as that in the compensation period t3. As the third control end Sn+1 outputs the low level signal, the twenty-sixth transistor T26 is switched on; and the reset voltage Vvx provided by the third power end Vx is transmitted to a first electrode (the first electrode is, for instance, an anode) of the fourth organic light-emitting diode OLED4 through the twenty-sixth transistor T26, namely the fourth initializing circuit initializes the fourth light-emitting circuit. For instance, the reset voltage Vvx is less than or equal to the second luminous voltage Velvss provided by the second power end ELVSS. Thus, the abnormal emission of the OLED can be prevented by initialization, for instance, the slightly bright emission of the OLED in the non-luminous period can be avoided. For instance, the present disclosure performs initialization discharge on the OLEDs, ensures the accuracy under a low gray scale and full black under a full dark frame, and effectively improves the contrast of the entire display panel.

For instance, in the pre-emission period t5, the first control end Sn-1 outputs a high level signal; the second control end Sn outputs a high level signal; the third control end Sn+1 outputs a high level signal; the fourth control end En outputs a high level signal; and the third data signal end Data3 outputs a high level signal.

FIG. 10E is a schematic diagram illustrating the conduction state in the pre-emission period t5 when the pixel circuit as illustrated in FIG. 8 provided by an embodiment of the present disclosure is driven by the drive timing as illustrated in FIG. 9. In the pre-emission period t5, the twentieth transistor T20, the twenty-first transistor T21, the twenty-second transistor T22, the twenty-fourth transistor T24, the twenty-fifth transistor T25 and the twenty-sixth transistor T26 are all in the off-states, and no electrical current path is formed in the pixel circuit. Because of the voltage storage function of the third storage capacitor C3, the twenty-third transistor T23 is kept in the on-state the same as that in the initialization period t4. For instance, the pre-emission period can provide a stable time period for the pixel circuit, so that the voltage and the current of various circuit elements can be kept in a stable state, and hence the circuit abnormality can be avoided.

For instance, in the emission period t6, the first control end Sn-1 outputs a high level signal; the second control end Sn outputs a high level signal; the third control end Sn+1 outputs a high level signal; the fourth control end En outputs a low level signal; and the third data signal end Data3 outputs a high level signal.

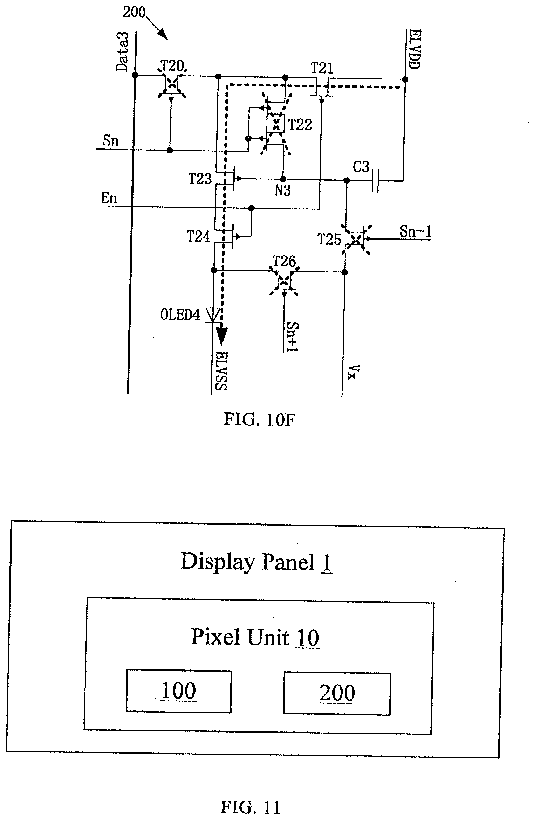

FIG. 10F is a schematic diagram illustrating the conduction state when the pixel circuit as illustrated in FIG. 8 provided by an embodiment of the present disclosure is driven by the drive timing as illustrated in FIG. 9. In the emission period t6, the twentieth transistor T20, the twenty-second transistor T22, the twenty-fifth transistor T25 and the twenty-sixth transistor T26 are all in the off-states. Because of the voltage storage function of the third storage capacitor C3, the twenty-third transistor T23 is kept in the on-state the same as that in the pre-emission period t5. As the fourth control end En outputs the low level signal, the twenty-first transistor T21 and the twenty-fourth transistor T24 are in the on-state; an electrical current path is formed by the first power end ELVDD, the twenty-first transistor T21, the twenty-third transistor T23, the twenty-fourth transistor T24, the fourth organic light-emitting diode OLED4 and the second power end ELVSS; and the fourth organic light-emitting diode OLED4 is driven by the twenty-third transistor T23 to emit light under the action of the first luminous voltage Velvdd provided by the first power end ELVDD and the second luminous voltage Velvss provided by the second power end ELVSS. That is to say, the fourth light-emitting control circuit controls the operation of the fourth light-emitting circuit; the first power end provides the first luminous voltage for the fourth light-emitting circuit; the second power end provides the second luminous voltage for the fourth light-emitting circuit; the fourth drive circuit drives the fourth light-emitting circuit; and the fourth light-emitting circuit emits light in the working process.

It should be noted that the driving method of the pixel circuit as illustrated in FIG. 8 may only comprise the reset period t2, the compensation period t3, the initialization period t4 and the emission period t6 and does not comprise the pre-reset period t1 and the pre-emission period t5, or comprises one of the pre-reset period t1 and the pre-emission period t5. No limitation will be given here.

For instance, as illustrated in FIG. 11, an embodiment of the present disclosure provides a display panel 1, which comprises the pixel circuit provided by any embodiment of the present disclosure.

For instance, the display panel 1 comprises a plurality of pixel units 10; and each pixel unit 10 includes the pixel circuit 100 provided by an embodiment of the present disclosure and the pixel circuit 200 provided by an embodiment of the present disclosure. That is to say, the display panel 1 provided by an embodiment of the present disclosure comprises the pixel circuit including the first organic light-emitting diode OLED1, the second organic light-emitting diode OLED2 and the third organic light-emitting diode OLED3 and the pixel circuit including the fourth organic light-emitting diode OLED4.

For instance, in the display panel 1 provided by an embodiment of the present disclosure, the first organic light-emitting diode OLED1 emits red light in the working process; the second organic light-emitting diode OLED2 emits green light in the working process; the third organic light-emitting diode OLED3 emits yellow light in the working process; and the fourth organic light-emitting diode OLED4 emits blue light in the working process.

For instance, the display panel provided by an embodiment of the present disclosure may be applied to any product or component with display function such as a mobile phone, a tablet PC, a TV set, a display, a notebook computer, a digital picture frame and a navigator.

For instance, in the display panel 1 provided by an embodiment of the present disclosure, the pixel circuit 100 simultaneously controls the first organic light-emitting diode OLED1, the second organic light-emitting diode OLED2 and the third organic light-emitting diode OLED3, reduces the number of the pixel circuits on the whole, reduces the area occupied by the pixel circuit, and improves the resolution of the display panel.

An embodiment of the present disclosure further provides a driving method, which comprises: a reset period, a compensation period, an initialization period and an emission period. In the reset period, the first control end Sn-1 outputs a valid signal; the second control end Sn outputs an invalid signal; the third control end Sn+1 outputs an invalid signal; the fourth control end En outputs an invalid signal; the first data signal end Data1 outputs a standby signal; the second data signal end Data2 outputs a standby signal; and the third data signal end Data3 outputs a standby signal. In the compensation period, the first control end Sn-1 outputs an invalid signal; the second control end Sn outputs a valid signal; the third control end Sn+1 outputs an invalid signal; the fourth control end En outputs an invalid signal; the first data signal end Data1 outputs a first data signal, the second data signal end Data2 outputting a standby signal, the third data signal end Data3 outputting a third data signal or a standby signal; alternatively, the first data signal end Data1 outputs a standby signal, the second data signal end Data2 outputting a second data signal, the third data signal end Data3 outputting the third data signal or the standby signal; alternatively, the first data signal end Data1 outputs the first data signal, the second data signal end Data2 outputting the second data signal, the third data signal end Data3 outputting the third data signal or the standby signal. In the initialization period, the first control end Sn-1 outputs an invalid signal; the second control end Sn outputs an invalid signal; the third control end Sn+1 outputs a valid signal; the fourth control end En outputs an invalid signal; the first data signal end Data1 outputs a standby signal; the second data signal end Data2 outputs a standby signal; and the third data signal end Data3 outputs a standby signal. In the emission period, the first control end Sn-1 outputs an invalid signal; the second control end Sn outputs an invalid signal; the third control end Sn+1 outputs an invalid signal; the fourth control end En outputs a valid signal; the first data signal end Data1 outputs a standby signal; the second data signal end Data2 outputs a standby signal; and the third data signal end Data3 outputs a standby signal.

For instance, the driving method provided by an embodiment of the present disclosure is used for driving the display panel 1.

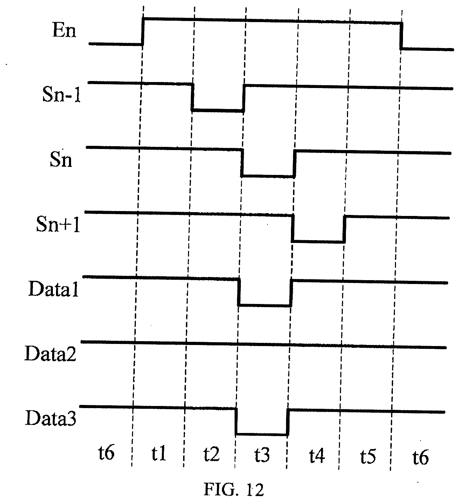

For instance, description is given here by taking the case that the first organic light-emitting diode OLED1, the fourth organic light-emitting diode OLED4, the second organic light-emitting diode OLED2 and the third organic light-emitting diode OLED3 in the display panel 1 are switched off as an example. As illustrated in FIG. 12, the embodiment of the present disclosure provides a driving method, which comprises: a pre-reset period t1, a reset period t2, a compensation period t3, an initialization period t4, a pre-emission period t5, and an emission period t6.

For instance, in the pre-reset period t1, the first control end Sn-1 outputs a high level signal; the second control end Sn outputs a high level signal; the third control end Sn+1 outputs a high level signal; the fourth control end En outputs a high level signal; the first data signal end Data1 outputs a high level signal; the second data signal end Data2 outputs a high level signal; and the third data signal end Data3 outputs a high level signal.

For instance, in the reset period t2, the first control end Sn-1 outputs a low level signal; the second control end Sn outputs a high level signal; the third control end Sn+1 outputs a high level signal; the fourth control end En outputs a high level signal; the first data signal end Data1 outputs a high level signal; the second data signal end Data2 outputs a high level signal; and the third data signal end Data3 outputs a high level signal.

For instance, in the compensation period t3, the first control end Sn-1 outputs a high level signal; the second control end Sn outputs a low level signal; the third control end Sn+1 outputs a high level signal; the fourth control end En outputs a high level signal; the first data signal end Data1 outputs a first data signal; the second data signal end Data2 outputs a high level signal; and the third data signal end Data3 outputs a third data signal.

For instance, in the initialization period t4, the first control end Sn-1 outputs a high level signal; the second control end Sn outputs a high level signal; the third control end Sn+1 outputs a low level signal; the fourth control end En outputs a high level signal; the first data signal end Data1 outputs a high level signal; the second data signal end Data2 outputs a high level signal; and the third data signal end Data3 outputs a high level signal.

For instance, in the pre-emission period t5, the first control end Sn-1 outputs a high level signal; the second control end Sn outputs a high level signal; the third control end Sn+1 outputs a high level signal; the fourth control end En outputs a high level signal; the first data signal end Data1 outputs a first data signal; the second data signal end Data2 outputs a high level signal; and the third data signal end Data3 outputs a third data signal.

For instance, in the emission period t6, the first control end Sn-1 outputs a high level signal; the second control end Sn outputs a high level signal; the third control end Sn+1 outputs a high level signal; the fourth control end En outputs a low level signal; the first data signal end Data1 outputs a high level signal; the second data signal end Data2 outputs a high level signal; and the third data signal end Data3 outputs a high level signal.

For instance, when the light-emitting states of the first organic light-emitting diode OLED1, the second organic light-emitting diode OLED2, the third organic light-emitting diode OLED3, and the fourth organic light-emitting diode OLED4 adopt other combinations, the drive timing may be correspondingly converted. No further description will be given here.

For instance, the display panel and the driving method, provided by an embodiment of the present disclosure, can perform initialization discharge on the OLEDs, ensure the accuracy under a low gray scale and full black under a full dark frame, and effectively improve the contrast of the entire display panel.

For instance, according to different display frames, the brightness of the third organic light-emitting diode OLED3 may be adopted to replace the combined brightness of the first organic light-emitting diode OLED1 and the second organic light-emitting diode OLED2. In a display frame in which the third organic light-emitting diode OLED3 is required to emit light, the first organic light-emitting diode OLED1, the second organic light-emitting diode OLED2 and the third organic light-emitting diode OLED3 emit light simultaneously, which is equivalent to increase the area of luminescent materials of the first organic light-emitting diode OLED1 and the second organic light-emitting diode OLED2 and reduce the luminous brightness of the first organic light-emitting diode OLED1 and the second organic light-emitting diode OLED2. Thus, the service life of the first organic light-emitting diode OLED1 and the second organic light-emitting diode OLED2 can be prolonged. In order to ensure the display effect, the light-emitting area of the fourth organic light-emitting diode OLED4 must be increased to be matched with the first organic light-emitting diode OLED1, the second organic light-emitting diode OLED2, and the third organic light-emitting diode OLED3, which is also equivalent to improve the service life of the fourth organic light-emitting diode OLED4.

## Claims

1. A pixel circuit (100), comprising:
a first organic light-emitting diode (OLED 1), a second organic light-emitting diode (OLED2), a third organic light-emitting diode (OLED3), a first transistor (T1), a second transistor (T2), a third transistor (T3), a fourth transistor (T4), a fifth transistor (T5), a sixth transistor (T6), a seventh transistor (T7), an eighth transistor (T8), a ninth transistor (T9), a tenth transistor (T10), a eleventh transistor (T11), a twelfth transistor (T12), a thirteenth transistor (T13), a fourteenth transistor (T14), a fifteenth transistor (T15), a sixteenth transistor (T16), a seventeenth transistor (T17), an eighteenth transistor (T18), a nineteenth transistor (T19), a first storage capacitor (C1), a second storage capacitor (C2), a first power end (ELVDD), a second power end (ELVSS), a third power end (Vx), a first data signal end (Data1), a second data signal end (Data2), a first control end (Sn-1), a second control end (Sn), a third control end (Sn+1) and a fourth control end (En);
wherein the first organic light-emitting diode (OLED1), the second organic light-emitting diode (OLED2), and the third organic light-emitting diode (OLED3) are configured to emit light in a working process;
the fourth transistor (T4) is configured to drive the first organic light-emitting diode (OLED1);
the first transistor (T1) is configured to write data into the fourth transistor (T4);
the third transistor (T3) is configured to compensate the fourth transistor (T4);
the sixth transistor (T6) is configured to reset the fourth transistor (T4);
the first storage capacitor (C1) is configured to store a driving voltage of the fourth transistor (T4);
the seventh transistor (T7) is configured to initialize the first organic light-emitting diode (OLED1);
the second transistor (T2) and the fifth transistor (T5) are configured to control ON and OFF operations of the first organic light-emitting diode (OLED1);
the seventeenth transistor (T17) is configured to drive the second organic light-emitting diode (OLED2);
the sixteenth transistor (T16) is configured to compensate the seventeenth transistor (T17);
the fifteenth transistor (T15) is configured to write data into the seventeenth transistor (T17);
the thirteenth transistor (T13) is configured to reset the seventeenth transistor (T17);
the second storage capacitor (C2) is configured to store a driving voltage of the seventeenth transistor (T17);
the nineteenth transistor (T19) configured to initialize the second organic light-emitting diode (OLED2);
the fourteenth transistor (T14) and the eighteenth transistor (T18) are configured to control ON and OFF operations of the second organic light-emitting diode (OLED2);
the eighth transistor (T8) and the eleventh transistor (T11) are configured to control ON and OFF operations of the third organic light-emitting diode (OLED3);
the ninth transistor (T9) and the tenth transistor (T10) are configured to drive the third organic light-emitting diode (OLED3);
the twelfth transistor (T12) is configured to initialize the third organic light-emitting diode (OLED3);
the first power end (ELVDD) is configured to provide a first luminous voltage (Velvdd) for the first organic light-emitting diode (OLED 1), the second organic light-emitting diode (OLED2) and the third organic light-emitting diode (OLED3);
the second power end (ELVSS) is configured to provide a second luminous voltage (Velvss) for the first organic light-emitting diode (OLED1), the second organic light-emitting diode (OLED2) and the third organic light-emitting diode (OLED3);
the third power end (Vx) is configured to provide a reset voltage for the sixth transistor (T6) and the thirteenth transistor (T13);
the first data signal end (Data1) is configured to provide a first data signal or a standby signal for the first transistor (T1);
the second data signal end (Data2) is configured to provide a second data signal or a standby signal for the fifteenth transistor (T15);
the first control end (Sn-1) is configured to provide a first control signal for controlling ON and OFF operations of the sixth transistor (T6) and the thirteenth transistor (T13);
the second control end (Sn) is configured to provide a second control signal for controlling ON and OFF operations of the first transistor (T1), the third transistor (T3), the fifteenth transistor (T15), and the sixteenth transistor (T16);
the third control end (Sn+1) is configured to provide a third control signal for controlling ON and OFF operations of the seventh transistor (T7), the twelfth transistor (T12) and the nineteenth transistor (T19); and
the fourth control end (En) is configured to provide a fourth control signal for controlling ON and OFF operations of the second transistor (T2), the fifth transistor (T5), the eighth transistor (T8), the eleventh transistor (T11), the fourteenth transistor (T14), and the eighteenth transistor (T18);
a source electrode of the first transistor (T1) is electrically connected with the first data signal end (Data1);
a gate electrode of the first transistor (T1), a gate electrode of the third transistor (T3), a gate electrode of the fifteenth transistor (T15) and a gate electrode of the sixteenth transistor (T16) are electrically connected with the second control end (Sn);
a gate electrode of the second transistor (T2), a gate electrode of the fifth transistor (T5), a gate electrode of the eighth transistor (T8), a gate electrode of the eleventh transistor (T11), a gate electrode of the fourteenth transistor (T14) and a gate electrode of the eighteenth transistor (T18) are electrically connected with the fourth control end (En);
a source electrode of the second transistor (T2), a first end of the first storage capacitor (C1), a source electrode of the eighth transistor (T8), a source electrode of the fourteenth transistor (T14) and a first end of the second storage capacitor (C2) are electrically connected with the first power end (ELVDD);
a drain electrode of the third transistor (T3) and a drain electrode of the sixth transistor (T6) are electrically connected with a first node (N1);
a drain electrode of the fourth transistor (T4) is electrically connected with a source electrode of the fifth transistor (T5);
a drain electrode of the fifth transistor (T5) and a drain electrode of the seventh transistor (T7) are electrically connected with a first end of the first organic light-emitting diode (OLED1);
a source electrode of the sixth transistor (T6), a source electrode of the seventh transistor (T7), a source electrode of the twelfth transistor (T12), a drain electrode of the thirteenth transistor (T13) and a source electrode of the nineteenth transistor (T19) are electrically connected with the third power end (Vx);
a gate electrode of the sixth transistor (T6) and a gate electrode of the thirteenth transistor (T13) are electrically connected with the first control end (Sn-1);
a gate electrode of the seventh transistor (T7), a gate electrode of the twelfth transistor (T12) and a gate electrode of the nineteenth transistor (T19) are electrically connected with the third control end (Sn+1);
a drain electrode of the eleventh transistor (T11) and a first end of the third organic light-emitting diode (OLED3), and a drain electrode of the twelfth transistor (T12) are electrically connected with each other;
a source electrode of the thirteenth transistor (T13) and a drain electrode of the sixteenth transistor (T16) are electrically connected with a second node (N2);
a source electrode of the fifteenth transistor (T15) is electrically connected with the second data signal end (Data2);
a drain electrode of the seventeenth transistor (T17) is electrically connected with a source electrode of the eighteenth transistor (T18);
a drain electrode of the eighteenth transistor (T18) and a drain electrode of the nineteenth transistor (T19) are electrically connected with a first end of the second organic light-emitting diode (OLED2); and
a second end of the first organic light-emitting diode (OLED1), a second end of the second organic light-emitting diode (OLED2), and a second end of the third organic light-emitting diode (OLED3) are electrically connected with the second power end (ELVSS);
**characterized in that**
a drain electrode of the first transistor (T1), a drain electrode of the second transistor (T2), a source electrode of the third transistor (T3), and a source electrode of the fourth transistor (T4) are electrically connected with each other;
a drain electrode of the eighth transistor (T8) is electrically connected with a source electrode of the ninth transistor (T9);
a drain electrode of the ninth transistor (T9) is electrically connected with a source electrode of the tenth transistor (T10);
a drain electrode of the tenth transistor (T10) is electrically connected with a source electrode of the eleventh transistor (T11);
a drain electrode of the fourteenth transistor (T14), a drain electrode of the fifteenth transistor (T15), a source electrode of the sixteenth transistor (T16), and a source electrode of the seventeenth transistor (T17) are electrically connected with each other;
a gate electrode of the fourth transistor (T4), a second end of the first storage capacitor (C1), and a gate electrode of the ninth transistor (T9) are directly electrically connected to each other, and
a gate electrode of the tenth transistor (T10), a gate electrode of the seventeenth transistor (T17), and a second end of the second storage capacitor (C2) are directly electrically connected to each other.

2. The pixel circuit (100) according to claim 1, wherein
the first organic light-emitting diode (OLED1) emits light of first color in the working process;
the second organic light-emitting diode (OLED2) emits light of second color in the working process;
the third organic light-emitting diode (OLED3) emits light of third color in the working process; and
a mixed color of the light of the first color and the light of the second color is the third color.

3. A display panel, comprising the pixel circuit (100) according to claim 1 or 2.

4. The display panel according to claim 3, further comprising:
a fourth organic light-emitting diode (OLED4), a twentieth transistor (T20), a twenty-first transistor (T21), a twenty-second transistor (T22), a twenty-third transistor (T23), a twenty-fourth transistor (T24), a twenty-fifth transistor (T25), a twenty-sixth transistor (T26), a third storage capacitor (C3), and a third data signal end (Data3);
wherein the fourth organic light-emitting diode (OLED4) is configured to emit light in the working process;
the twenty-third transistor (T23) is configured to drive the fourth organic light-emitting diode (OLED4);
the twenty-second transistor (T22) is configured to compensate the twenty-third transistor (T23);
the twentieth transistor (T20) is configured to write data into the twenty-third transistor (T23);
the twenty-fifth transistor (T25) is configured to reset the twenty-third transistor (T23);
the third storage capacitor (C3) is configured to store a driving voltage of the twenty-third transistor (T23);
the twenty-sixth transistor (T26) is configured to initialize the fourth organic light-emitting diode (OLED4);
the twenty-first transistor (T21) and the twenty-fourth transistor (T24) are configured to control ON and OFF operations of the fourth organic light-emitting diode (OLED4);
the first power end (ELVDD) is configured to provide the first luminous voltage (Velvdd) for the fourth organic light-emitting diode (OLED4);
the second power end (ELVSS) is configured to provide the second luminous voltage (Velvss) for the fourth organic light-emitting diode (OLED4);
the third power end (Vx) is configured to provide the reset voltage for the twenty-fifth transistor (T25);
the third data signal end (Data3) is configured to provide a third data signal or a standby signal for the twentieth transistor (T20);
the first control end (Sn-1) is configured to provide the first control signal for controlling ON and OFF operations of the twenty-fifth transistor (T25);
the second control end (Sn) is configured to provide the second control signal for controlling ON and OFF operations of the twentieth transistor (T20) and the twenty-second transistor (T22);
the third control end (Sn+1) is configured to provide the third control signal for controlling ON and OFF operations of the twenty-sixth transistor (T26); and
the fourth control end (En) is configured to provide the fourth control signal for controlling ON and OFF operations of the twenty-first transistor (T21) and the twenty-fourth transistor (T24);
a source electrode of the twentieth transistor (T20) is electrically connected with the third data signal end (Data3);
a gate electrode of the twentieth transistor (T20) and a gate electrode of the twenty-second transistor (T22) are electrically connected with the second control end (Sn);
a drain electrode of the twentieth transistor (T20), a drain electrode of the twenty-first transistor (T21), a source electrode of the twenty-second transistor (T22), and a source electrode of the twenty-third transistor (T23) are electrically connected with each other;
a gate electrode of the twenty-first transistor (T21) and a gate electrode of the twenty-fourth transistor (T24) are electrically connected with the fourth control end (En);
a source electrode of the twenty-first transistor (T21) and a first end of the third storage capacitor (C3) are electrically connected with the first power end (ELVDD);
a drain electrode of the twenty-second transistor (T22), a gate electrode of the twenty-third transistor (T23), a drain electrode of the twenty-fifth transistor (T25), and a second end of the third storage capacitor (C3) are electrically connected with a third node (N3);
a drain electrode of the twenty-third transistor (T23) is electrically connected with a source electrode of the twenty-fourth transistor (T24);
a drain electrode of the twenty-fourth transistor (T24) and a drain electrode of the twenty-sixth transistor (T26) are electrically connected with a first end of the fourth organic light-emitting diode (OLED4);
a source electrode of the twenty-fifth transistor (T25) and a source electrode of the twenty-sixth transistor (T26) are electrically connected with the third power end (Vx);
a gate electrode of the twenty-fifth transistor (T25) is electrically connected with the first control end (Sn-1);
a gate electrode of the twenty-sixth transistor (T26) is electrically connected with the third control end (Sn+1); and
a second end of the fourth organic light-emitting diode (OLED4) is electrically connected with the second power end (ELUSS),
wherein the first organic light-emitting diode (OLED1) emits red light, the second organic light-emitting diode (OLED2) emits green light; the third organic light-emitting diode (OLED3) emits yellow light and the fourth organic light-emitting diode (OLED4) emits blue light.

5. A driving method applied to the driving the pixel circuit (100) according to claim 1 or 2, comprising: a reset period (t2), a compensation period (t3), an initialization period (t4), and an emission period (t6), wherein
in the reset period (t2):
the first control end (Sn-1) outputs an active signal;
the second control end (Sn) outputs an inactive signal;
the third control end (Sn+1) outputs an inactive signal;
the fourth control end (En) outputs an inactive signal; and
the first data signal end (Data1) outputs a standby signal; the second data signal end (Data2) outputs a standby signal;
in the compensation period (t3):
the first control end (Sn-1) outputs an inactive signal;
the second control end (Sn) outputs an active signal;
the third control end (Sn+1) outputs an inactive signal;
the fourth control end (En) outputs an inactive signal; and
the first data signal end (Data1) outputs a first data signal, and the second data signal end (Data2) outputs a standby signal; or the first data signal end (Data1) outputs a standby signal, and the second data signal end (Data2) outputs a second data signal; or the first data signal end (Data1) outputs the first data signal, and the second data signal end (Data2) outputs the second data signal;
in the initialization period (t4):
the first control end (Sn-1) outputs an inactive signal;
the second control end (Sn) outputs an inactive signal;
the third control end (Sn+1) outputs an active signal;
the fourth control end (En) outputs an inactive signal;
the first data signal end (Data1) outputs a standby signal; and
the second data signal end (Data2) outputs a standby signal; and
in the emission period (t6):
the first control end (Sn-1) outputs an inactive signal;
the second control end (Sn) outputs an inactive signal;
the third control end (Sn+1) outputs an inactive signal;
the fourth control end (En) outputs an active signal;
the first data signal end (Data1) outputs a standby signal; and
the second data signal end (Data2) outputs a standby signal.

6. The driving method according to claim 5, further comprising: a pre-reset period (t1) and a pre-emission period (t5), wherein the pre-reset period (t1) is after the emission period (t6) and before the reset period (t2); the pre-emission period (t5) is after the initialization period (t4) and before the emission period (t6);
in the pre-reset period (t1):
the first control end (Sn-1) outputs an inactive signal;
the second control end (Sn) outputs an inactive signal;
the third control end (Sn+1) outputs an inactive signal;
the fourth control end (En) outputs an inactive signal;
the first data signal end (Data1) outputs a standby signal; and
the second data signal end (Data2) outputs a standby signal; and
in the pre-emission period (t5):
the first control end (Sn-1) outputs an inactive signal;
the second control end (Sn) outputs an inactive signal;
the third control end (Sn+1) outputs an inactive signal;
the fourth control end (En) outputs an inactive signal; the first data signal end (Data1) outputs a standby signal; and
the second data signal end (Data2) outputs a standby signal.

7. The driving method according to claim 5, wherein in the compensation period (t3):
when the first data signal end (Data1) outputs the first data signal and the second data signal end (Data2) outputs the standby signal, the first organic light-emitting diode (OLED1) emits light independently, and the first data signal is configured to control a luminous brightness of the first organic light-emitting diode (OLED1);
when the first data signal end (Data1) outputs the standby signal and the second data signal end (Data2) outputs the second data signal, the second organic light-emitting diode (OLED2) emits light independently, and the second data signal is configured to control a luminous brightness of the second organic light-emitting diode (OLED2); and
when the first data signal end (Data1) outputs the first data signal and the second data signal end (Data2) outputs the second data signal, the first organic light-emitting diode (OLED1), the second organic light-emitting diode (OLED2) and the third organic light-emitting diode (OLED3) emit light simultaneously; the first data signal is configured to control the luminous brightness of the first organic light-emitting diode (OLED1); the second data signal is configured to control the luminous brightness of the second organic light-emitting diode (OLED2); and in a case where an output voltage of the first data signal (Vdata1) is smaller than an output voltage of the second data signal (Vdata2), the first data signal is used to control the luminous brightness of the third organic light-emitting diode (OLED3) and in a case where an output voltage of the second data signal (Vdata2) is smaller than an output voltage of the first data signal (Vdata1), the second data signal is used to control the luminous brightness of the third organic light-emitting diode (OLED3).

## Patentansprüche

1. Pixels-Schaltung (100), mit:
einer ersten organischen Licht emittierenden Diode (OLED1), einer zweiten organischen Licht emittierenden Diode (OLED2), einer dritten organischen Licht emittierenden Diode (OLED3), einem ersten Transistor (T1), einem zweiten Transistor (T2), einem dritten Transistor (T3), einem vierten Transistor (T4), einem fünften Transistor (T5), einem sechsten Transistor (T6), einem siebten Transistor (T7), einem achten Transistor (T8), einem neunten Transistor (T9), einem zehnten Transistor (T10), einem elften Transistor (T11), einem zwölften Transistor (T12), einem dreizehnten Transistor (T13), einem vierzehnten Transistor (T14), einem fünfzehnten Transistor (T15), einem sechzehnten Transistor (T16), einem siebzehnten Transistor (T17), einem achtzehnten Transistor (T18), einem neunzehnten Transistor (T19), einem ersten Speicherkondensator (C1), einem zweiten Speicherkondensator (C2), einem ersten Leistungsende (ELVDD), einem zweiten Leistungsende (ELUSS), einem dritten Leistungsende (Vx), einem ersten Datensignalende (Data1), einem zweiten Datensignalende (Data2), einem ersten Steuerende (Sn-1), einem zweiten Steuerende (Sn), einem dritten Steuerende (Sn+1) und einem vierten Steuerende (En);
wobei die erste organische Leuchtdiode (OLED1), die zweite organische Leuchtdiode (OLED2) und die dritte organische Leuchtdiode (OLED3) konfiguriert sind, Licht in einem Arbeitsprozess zu emittieren;
der vierte Transistor (T4) konfiguriert ist, die erste organische lichtemittierende Diode (OLED 1) anzusteuern;
der erste Transistor (T1) konfiguriert ist, Daten in den vierten Transistor (T4) zu schreiben;
der dritte Transistor (T3) konfiguriert ist, den vierten Transistor (T4) zu kompensieren;
der sechste Transistor (T6) konfiguriert ist, den vierten Transistor (T4) zurückzusetzen;
der erste Speicherkondensator (C1) konfiguriert ist, eine Ansteuerspannung des vierten Transistors (T4) zu speichern;
der siebte Transistor (T7) konfiguriert ist, die erste organische Licht emittierende Diode (OLED1) zu initialisieren;
der zweite Transistor (T2) und der fünfte Transistor (T5) konfiguriert sind, den EIN- und AUS-Betrieb der ersten organischen lichtemittierenden Diode (OLED1) zu steuern;
der siebzehnte Transistor (T17) konfiguriert ist, die zweite organische lichtemittierende Diode (OLED2) zu steuern;
der sechzehnte Transistor (T16) konfiguriert ist, den siebzehnten Transistor (T17) zu kompensieren;
der fünfzehnte Transistor (T15) konfiguriert ist, Daten in den siebzehnten Transistor (T17) zu schreiben;
der dreizehnte Transistor (T13) konfiguriert ist, den siebzehnten Transistor (T17) zurückzusetzen;
der zweite Speicherkondensator (C2) konfiguriert ist, eine Treiberspannung des siebzehnten Transistors (T17) zu speichern;
der neunzehnte Transistor (T19) konfiguriert ist, die zweite organische Licht emittierende Diode (OLED2) zu initialisieren;
der vierzehnte Transistor (T14) und der achtzehnte Transistor (T18) konfiguriert sind, den EIN- und AUS-Betrieb der zweiten organischen lichtemittierenden Diode (OLED2) zu steuern;
der achte Transistor (T8) und der elfte Transistor (T11) konfiguriert sind, den EIN- und AUS-Betrieb der dritten organischen lichtemittierenden Diode (OLED3) zu steuern;
der neunte Transistor (T9) und der zehnte Transistor (T10) konfiguriert sind, die dritte organische lichtemittierende Diode (OLED3) zu steuern;
der zwölfte Transistor (T12) konfiguriert ist, die dritte organische Licht emittierende Diode (OLED3) zu initialisieren;
die erste Stromversorgungsseite (ELVDD) konfiguriert ist, eine erste Lichtspannung (Velvdd) für die erste organische lichtemittierende Diode (OLED1), die zweite organische lichtemittierende Diode (OLED2) und die dritte organische lichtemittierende Diode (OLED3) bereitzustellen;
das zweite Leistungsende (ELVSS) konfiguriert ist, eine zweite Lichtspannung (Velvss) für die erste organische lichtemittierende Diode (OLED1), die zweite organische lichtemittierende Diode (OLED2) und die dritte organische lichtemittierende Diode (OLED3) bereitzustellen;
das dritte Leistungsende (Vx) konfiguriert ist, eine Rücksetzspannung für den sechsten Transistor (T6) und den dreizehnten Transistor (T13) bereitzustellen;
das erste Datensignalende (Data1) konfiguriert ist, ein erstes Datensignal oder ein Standby-Signal für den ersten Transistor (T1) bereitzustellen;
das zweite Datensignalende (Data2) konfiguriert ist, ein zweites Datensignal oder ein Standby-Signal für den fünfzehnten Transistor (T15) zu liefern;
das erste Steuerende (Sn-1) konfiguriert ist, ein erstes Steuersignal zur Steuerung des EIN- und AUS-Betriebs des sechsten Transistors (T6) und des dreizehnten Transistors (T13) bereitzustellen;
das zweite Steuerende (Sn) konfiguriert ist, ein zweites Steuersignal zum Steuern des EIN- und AUS-Betriebs des ersten Transistors (T1), des dritten Transistors (T3), des fünfzehnten Transistors (T15) und des sechzehnten Transistors (T16) zu liefern;
das dritte Steuerende (Sn+1) konfiguriert ist, ein drittes Steuersignal zum Steuern des EIN- und AUS-Betriebs des siebten Transistors (T7), des zwölften Transistors (T12) und des neunzehnten Transistors (T19) zu liefern; und
das vierte Steuerende (En) konfiguriert ist, ein viertes Steuersignal zum Steuern des EIN- und AUS-Betriebs des zweiten Transistors (T2), des fünften Transistors (T5), des achten Transistors (T8), des elften Transistors (T11), des vierzehnten Transistors (T14) und des achtzehnten Transistors (T18) bereitzustellen;
eine Source-Elektrode des ersten Transistors (T1) elektrisch mit dem ersten Datensignalende (Data1) verbunden ist;
eine Gate-Elektrode des ersten Transistors (T1), eine Gate-Elektrode des dritten Transistors (T3), eine Gate-Elektrode des fünfzehnten Transistors (T15) und eine Gate-Elektrode des sechzehnten Transistors (T16) elektrisch mit dem zweiten Steuerende (Sn) verbunden sind;
eine Gate-Elektrode des zweiten Transistors (T2), eine Gate-Elektrode des fünften Transistors (T5), eine Gate-Elektrode des achten Transistors (T8), eine Gate-Elektrode des elften Transistors (T11), eine Gate-Elektrode des vierzehnten Transistors (T14) und eine Gate-Elektrode des achtzehnten Transistors (T18) elektrisch mit dem vierten Steuerende (En) verbunden sind;
eine Source-Elektrode des zweiten Transistors (T2), ein erstes Ende des ersten Speicherkondensators (C1), eine Source-Elektrode des achten Transistors (T8), eine Source-Elektrode des vierzehnten Transistors (T14) und ein erstes Ende des zweiten Speicherkondensators (C2) elektrisch mit der ersten Energieseite (ELVDD) verbunden sind;
eine Drain-Elektrode des dritten Transistors (T3) und eine Drain-Elektrode des sechsten Transistors (T6) elektrisch mit einem ersten Knoten (N1) verbunden sind;
eine Drain-Elektrode des vierten Transistors (T4) elektrisch mit einer Source-Elektrode des fünften Transistors (T5) verbunden ist;
eine Drain-Elektrode des fünften Transistors (T5) und eine Drain-Elektrode des siebten Transistors (T7) elektrisch mit einem ersten Ende der ersten organischen Licht emittierenden Diode (OLED1) verbunden sind;
eine Source-Elektrode des sechsten Transistors (T6), eine Source-Elektrode des siebten Transistors (T7), eine Source-Elektrode des zwölften Transistors (T12), eine Drain-Elektrode des dreizehnten Transistors (T13) und eine Source-Elektrode des neunzehnten Transistors (T19) elektrisch mit dem dritten Energieende (Vx) verbunden sind;
eine Gate-Elektrode des sechsten Transistors (T6) und eine Gate-Elektrode des dreizehnten Transistors (T13) elektrisch mit dem ersten Steuerungsende (Sn-1) verbunden sind;
eine Gate-Elektrode des siebten Transistors (T7), eine Gate-Elektrode des zwölften Transistors (T12) und eine Gate-Elektrode des neunzehnten Transistors (T19) elektrisch mit dem dritten Steuerende (Sn+1) verbunden sind;
eine Drain-Elektrode des elften Transistors (T11) und ein erstes Ende der dritten organischen Leuchtdiode (OLED3), und eine Drain-Elektrode des zwölften Transistors (T12) elektrisch miteinander verbunden sind;
eine Source-Elektrode des dreizehnten Transistors (T13) und eine Drain-Elektrode des sechzehnten Transistors (T16) elektrisch mit einem zweiten Knoten (N2) verbunden sind;
eine Source-Elektrode des fünfzehnten Transistors (T15) elektrisch mit dem zweiten Datensignalende (Data2) verbunden ist;
eine Drain-Elektrode des siebzehnten Transistors (T17) elektrisch mit einer Source-Elektrode des achtzehnten Transistors (T18) verbunden ist;
eine Drain-Elektrode des achtzehnten Transistors (T18) und eine Drain-Elektrode des neunzehnten Transistors (T19) elektrisch mit einem ersten Ende der zweiten organischen lichtemittierenden Diode (OLED2) verbunden sind; und
ein zweites Ende der ersten organischen Licht-emittierenden Diode (OLED1), ein zweites Ende der zweiten organischen Licht-emittierenden Diode (OLED2) und ein zweites Ende der dritten organischen Licht-emittierenden Diode (OLED3) elektrisch mit dem zweiten Leistungsende (ELVSS) verbunden sind;
**dadurch gekennzeichnet, dass**
eine Drain-Elektrode des ersten Transistors (T1), eine Drain-Elektrode des zweiten Transistors (T2), eine Source-Elektrode des dritten Transistors (T3), und eine Source-Elektrode des vierten Transistors (T4) elektrisch miteinander verbunden sind;
eine Drain-Elektrode des achten Transistors (T8) elektrisch mit einer Source-Elektrode des neunten Transistors (T9) verbunden ist;
eine Drain-Elektrode des neunten Transistors (T9) elektrisch mit einer Source-Elektrode des zehnten Transistors (T10) verbunden ist;
eine Drain-Elektrode des zehnten Transistors (T10) elektrisch mit einer Source-Elektrode des elften Transistors (T11) verbunden ist;
eine Drain-Elektrode des vierzehnten Transistors (T14), eine Drain-Elektrode des fünfzehnten Transistors (T15), eine Source-Elektrode des sechzehnten Transistors (T16), und eine Source-Elektrode des siebzehnten Transistors (T17) elektrisch miteinander verbunden sind;
eine Gate-Elektrode des vierten Transistors (T4), ein zweites Ende des ersten Speicherkondensators (C1) und eine Gate-Elektrode des neunten Transistors (T9) direkt elektrisch miteinander verbunden sind, und
eine Gate-Elektrode des zehnten Transistors (T10), eine Gate-Elektrode des siebzehnten Transistors (T17) und ein zweites Ende des zweiten Speicherkondensators (C2) direkt elektrisch miteinander verbunden sind.

2. Pixel-Schaltung (100) nach Anspruch 1, wobei
die erste organische Leuchtdiode (OLED1) im Arbeitsprozess Licht der ersten Farbe emittiert;
die zweite organische Leuchtdiode (OLED2) während des Arbeitsprozesses Licht einer zweiten Farbe emittiert,
die dritte organische Leuchtdiode (OLED3) emittiert im Arbeitsprozess Licht der dritten Farbe; und
eine Mischfarbe des Lichts der ersten Farbe und des Lichts der zweiten Farbe die dritte Farbe ist.

3. Anzeige-Panel mit der Pixel-Schaltung (100) nach Anspruch 1 oder 2.

4. Anzeige-Panel nach Anspruch 3, ferner mit:
einer vierten organischen Leuchtdiode (OLED4), einem zwanzigsten Transistor (T20), einem einundzwanzigsten Transistor (T21), einem zweiundzwanzigsten Transistor (T22), einem dreiundzwanzigsten Transistor (T23), einem vierundzwanzigsten Transistor (T24), einem fünfundzwanzigsten Transistor (T25), einem sechsundzwanzigsten Transistor (T26), einem dritten Speicherkondensator (C3), und einem dritten Datensignalende (Data3);
wobei die vierte organische Leuchtdiode (OLED4) konfiguriert ist, im Arbeitsprozess Licht zu emittieren;
der dreiundzwanzigste Transistor (T23) konfiguriert ist, die vierte organische lichtemittierende Diode (OLED4) zu steuern;
der zweiundzwanzigste Transistor (T22) konfiguriert ist, den dreiundzwanzigsten Transistor (T23) zu kompensieren;
der zwanzigste Transistor (T20) konfiguriert ist, Daten in den dreiundzwanzigsten Transistor (T23) zu schreiben;
der fünfundzwanzigste Transistor (T25) konfiguriert ist, den dreiundzwanzigsten Transistor (T23) zurückzusetzen;
der dritte Speicherkondensator (C3) konfiguriert ist, eine Treiberspannung des dreiundzwanzigsten Transistors (T23) zu speichern;
der sechsundzwanzigste Transistor (T26) konfiguriert ist, die vierte organische Licht emittierende Diode (OLED4) zu initialisieren;
der einundzwanzigste Transistor (T21) und der vierundzwanzigste Transistor (T24) konfiguriert sind, den EIN- und AUS-Betrieb der vierten organischen lichtemittierenden Diode (OLED4) zu steuern;
die erste Stromversorgungsseite (ELVDD) konfiguriert ist, die erste Lichtspannung (Velvdd) für die vierte organische lichtemittierende Diode (OLED4) bereitzustellen;
die zweite Stromversorgungsseite (ELVSS) konfiguriert ist, die zweite Leuchtspannung (Velvss) für die vierte organische Leuchtdiode (OLED4) bereitzustellen;
die dritte Stromversorgungsseite (Vx) konfiguriert ist, die Rücksetzspannung für den fünfundzwanzigsten Transistor (T25) bereitzustellen;
das dritte Datensignalende (Data3) konfiguriert ist, ein drittes Datensignal oder ein Standby-Signal für den zwanzigsten Transistor (T20) bereitzustellen;
das erste Steuerende (Sn-1) konfiguriert ist, das erste Steuersignal zur Steuerung des EIN- und AUS-Betriebs des fünfundzwanzigsten Transistors (T25) zu liefern;
das zweite Steuerende (Sn) konfiguriert ist, das zweite Steuersignal zur Steuerung des EIN- und AUS-Betriebs des zwanzigsten Transistors (T20) und des zweiundzwanzigsten Transistors (T22) zu liefern;
das dritte Steuerende (Sn+1) konfiguriert ist, das dritte Steuersignal zur Steuerung des EIN- und AUS-Betriebs des sechsundzwanzigsten Transistors (T26) zu liefern; und
das vierte Steuerende (En) konfiguriert ist, das vierte Steuersignal zum Steuern des EIN- und AUS-Betriebs des einundzwanzigsten Transistors (T21) und des vierundzwanzigsten Transistors (T24) zu liefern;
eine Source-Elektrode des zwanzigsten Transistors (T20) elektrisch mit dem dritten Datensignalende (Data3) verbunden ist;
eine Gate-Elektrode des zwanzigsten Transistors (T20) und eine Gate-Elektrode des zweiundzwanzigsten Transistors (T22) elektrisch mit dem zweiten Steuerende (Sn) verbunden sind;
eine Drain-Elektrode des zwanzigsten Transistors (T20), eine Drain-Elektrode des einundzwanzigsten Transistors (T21), eine Source-Elektrode des zweiundzwanzigsten Transistors (T22), und eine Source-Elektrode des dreiundzwanzigsten Transistors (T23) elektrisch miteinander verbunden sind;
eine Gate-Elektrode des einundzwanzigsten Transistors (T21) und eine Gate-Elektrode des vierundzwanzigsten Transistors (T24) sind elektrisch mit dem vierten Steuerende (En) verbunden;
eine Source-Elektrode des einundzwanzigsten Transistors (T21) und ein erstes Ende des dritten Speicherkondensators (C3) elektrisch mit dem ersten Leistungsende (ELVDD) verbunden sind;
eine Drain-Elektrode des zweiundzwanzigsten Transistors (T22), eine Gate-Elektrode des dreiundzwanzigsten Transistors (T23), eine Drain-Elektrode des fünfundzwanzigsten Transistors (T25) und ein zweites Ende des dritten Speicherkondensators (C3) elektrisch mit einem dritten Knoten (N3) verbunden sind;
eine Drain-Elektrode des dreiundzwanzigsten Transistors (T23) elektrisch mit einer Source-Elektrode des vierundzwanzigsten Transistors (T24) verbunden ist;
eine Drain-Elektrode des vierundzwanzigsten Transistors (T24) und eine Drain-Elektrode des sechsundzwanzigsten Transistors (T26) elektrisch mit einem ersten Ende der vierten organischen Licht emittierenden Diode (OLED4) verbunden sind;
eine Source-Elektrode des fünfundzwanzigsten Transistors (T25) und eine Source-Elektrode des sechsundzwanzigsten Transistors (T26) elektrisch mit dem dritten Energieende (Vx) verbunden sind;
eine Gate-Elektrode des fünfundzwanzigsten Transistors (T25) elektrisch mit dem ersten Steuerungsende (Sn-1) verbunden ist;
eine Gate-Elektrode des sechsundzwanzigsten Transistors (T26) elektrisch mit dem dritten Steuerende (Sn+1) verbunden ist; und
ein zweites Ende der vierten organischen Licht-emittierenden Diode (OLED4) ist elektrisch mit dem zweiten Leistungsende (ELVSS) verbunden,
wobei die erste organische Leuchtdiode (OLED1) rotes Licht emittiert, die zweite organische Leuchtdiode (OLED2) grünes Licht emittiert, die dritte organische Leuchtdiode (OLED3) gelbes Licht emittiert und die vierte organische Leuchtdiode (OLED4) blaues Licht emittiert.

5. Ansteuerungsverfahren, das auf die Ansteuerung der Pixel-Schaltung (100) nach Anspruch 1 oder 2 angewendet wird, mit: einer Rücksetzperiode (t2), einer Kompensationsperiode (t3), einer Initialisierungsperiode (t4), und einer Emissionsperiode (t6), wobei
in der Rücksetzperiode (t2):
das erste Steuerende (Sn-1) ein aktives Signal ausgibt;
das zweite Steuerende (Sn) ein inaktives Signal ausgibt;
das dritte Steuerende (Sn+1) ein inaktives Signal ausgibt;
das vierte Steuerende (En) ein inaktives Signal ausgibt; und
das erste Datensignalende (Data1) ein Standby-Signal ausgibt;
das zweite Datensignalende (Data2) ein Standby-Signal ausgibt;
in der Ausgleichsperiode (t3):
das erste Steuerende (Sn-1) ein inaktives Signal ausgibt;
das zweite Steuerende (Sn) ein aktives Signal ausgibt;
das dritte Steuerende (Sn+1) ein inaktives Signal ausgibt;
das vierte Steuerende (En) ein inaktives Signal ausgibt; und
das erste Datensignalende (Data1) ein erstes Datensignal ausgibt, und das zweite Datensignalende (Data2) ein Standby-Signal ausgibt; oder das erste Datensignalende (Data1) ein Standby-Signal ausgibt, und das zweite Datensignalende (Data2) ein zweites Datensignal ausgibt; oder das erste Datensignalende (Data1) das erste Datensignal ausgibt, und das zweite Datensignalende (Data2) das zweite Datensignal ausgibt;
in der Initialisierungsperiode (t4):
das erste Steuerende (Sn-1) ein inaktives Signal ausgibt;
das zweite Steuerende (Sn) ein inaktives Signal ausgibt;
das dritte Steuerende (Sn+1) ein aktives Signal ausgibt;
das vierte Steuerende (En) ein inaktives Signal ausgibt;
das erste Datensignalende (Data1) ein Standby-Signal ausgibt; und
das zweite Datensignalende (Data2) ein Standby-Signal ausgibt; und
in der Emissionsperiode (t6):
das erste Steuerende (Sn-1) ein inaktives Signal ausgibt;
das zweite Steuerende (Sn) ein inaktives Signal ausgibt;
das dritte Steuerende (Sn+1) ein inaktives Signal ausgibt;
das vierte Steuerende (En) ein aktives Signal ausgibt;
das erste Datensignalende (Data1) ein Standby-Signal ausgibt; und
das zweite Datensignalende (Data2) ein Standby-Signal ausgibt.

6. Ansteuerungsverfahren nach Anspruch 5, ferner mit: einer Vor-Rücksetzperiode (t1) und einer Vor-Emissionsperiode (t5), wobei die Vor-Rücksetzperiode (t1) nach der Emissionsperiode (t6) und vor der Rücksetzperiode (t2) liegt; die Vor-Emissionsperiode (t5) nach der Initialisierungsperiode (t4) und vor der Emissionsperiode (t6) liegt;
in der Vor-Rücksetzperiode (11):
das erste Steuerende (Sn-1) ein inaktives Signal ausgibt;
das zweite Steuerende (Sn) ein inaktives Signal ausgibt;
das dritte Steuerende (Sn+1) ein inaktives Signal ausgibt;
das vierte Steuerende (En) ein inaktives Signal ausgibt;
das erste Datensignalende (Data1) ein Standby-Signal ausgibt; und
das zweite Datensignalende (Data2) ein Standby-Signal ausgibt; und
in der Vor-Emissionsperiode (t5):
das erste Steuerende (Sn-1) ein inaktives Signal ausgibt;
das zweite Steuerende (Sn) ein inaktives Signal ausgibt;
das dritte Steuerende (Sn+1) ein inaktives Signal ausgibt;
das vierte Steuerende (En) ein inaktives Signal ausgibt;
das erste Datensignalende (Data1) ein Standby-Signal ausgibt; und
das zweite Datensignalende (Data2) ein Standby-Signal ausgibt.

7. Ansteuerungsverfahren nach Anspruch 5, wobei in der Kompensationsperiode (t3):
wenn das erste Datensignalende (Data1) das erste Datensignal ausgibt und das zweite Datensignalende (Data2) das Standby-Signal ausgibt, die erste organische Leuchtdiode (OLED1) unabhängig Licht emittiert und das erste Datensignal konfiguriert ist, eine Lichthelligkeit der ersten organischen Leuchtdiode (OLED1) zu steuern;
wenn das erste Datensignalende (Data1) das Bereitschaftssignal ausgibt und das zweite Datensignalende (Data2) das zweite Datensignal ausgibt, die zweite organische Leuchtdiode (OLED2) unabhängig Licht emittiert, und das zweite Datensignal konfiguriert ist, eine Lichthelligkeit der zweiten organischen Leuchtdiode (OLED2) zu steuern; und
wenn das erste Datensignalende (Data1) das erste Datensignal ausgibt und das zweite Datensignalende (Data2) das zweite Datensignal ausgibt, die erste organische Leuchtdiode (OLED1), die zweite organische Leuchtdiode (OLED2) und die dritte organische Leuchtdiode (OLED3) gleichzeitig Licht emittieren; das erste Datensignal konfiguriert ist, die Lichthelligkeit der ersten organischen Licht emittierenden Diode (OLED1) zu steuern; das zweite Datensignal konfiguriert ist, die Lichthelligkeit der zweiten organischen Licht emittierenden Diode (OLED2) zu steuern; und in einem Fall, in dem eine Ausgangsspannung des ersten Datensignals (Vdata1) kleiner als eine Ausgangsspannung des zweiten Datensignals (Vdata2) ist, das erste Datensignal verwendet wird, um die Lichthelligkeit der dritten organischen Leuchtdiode (OLED3) zu steuern, und in einem Fall, in dem eine Ausgangsspannung des zweiten Datensignals (Vdata2) kleiner ist als eine Ausgangsspannung des ersten Datensignals (Vdata1), das zweite Datensignal verwendet wird, um die Lichthelligkeit der dritten organischen Leuchtdiode (OLED3) zu steuern.

## Revendications

1. Circuit de pixels (100), comprenant :
une première diode électroluminescente organique (OLED1), une deuxième diode électroluminescente organique (OLED2), une troisième diode électroluminescente organique (OLED3), un premier transistor (T1), un deuxième transistor (T2), un troisième transistor (T3), un quatrième transistor (T4), un cinquième transistor (T5), un sixième transistor (T6), un septième transistor (T7), un huitième transistor (T8), un neuvième transistor (T9), un dixième transistor (T10), un onzième transistor (T11), un douzième transistor (T12), un treizième transistor (T13), un quatorzième transistor (T14), un quinzième transistor (T15), un seizième transistor (T16), un dix-septième transistor (T17), un dix-huitième transistor (T18), un dix-neuvième transistor (T19), un premier condensateur de stockage (C1), un deuxième condensateur de stockage (C2), une première extrémité d'alimentation électrique (ELVDD), une deuxième extrémité d'alimentation électrique (ELVSS), une troisième extrémité d'alimentation électrique (Vx), une première extrémité de signal de données (Datai), une deuxième extrémité de signal de données (Data2), une première extrémité de commande (Sn-1), une deuxième extrémité de commande (Sn), une troisième extrémité de commande (Sn+1) et une quatrième extrémité de commande (En) ;
dans lequel la première diode électroluminescente organique (OLED1), la deuxième diode électroluminescente organique (OLED2) et la troisième diode électroluminescente organique (OLED3) sont configurées pour émettre de la lumière lors d'un processus de travail ;
le quatrième transistor (T4) est configuré pour piloter la première diode électroluminescente organique (OLED1) ;
le premier transistor (T1) est configuré pour écrire des données dans le quatrième transistor (T4) ;
le troisième transistor (T3) est configuré pour compenser le quatrième transistor (T4) ;
le sixième transistor (T6) est configuré pour réinitialiser le quatrième transistor (T4) ;
le premier condensateur de stockage (C1) est configuré pour stocker une tension de pilotage du quatrième transistor (T4) ;
le septième transistor (T7) est configuré pour initialiser la première diode électroluminescente organique (OLED1) ;
le deuxième transistor (T2) et le cinquième transistor (T5) sont configurés pour commander les opérations d'activation et de désactivation de la première diode électroluminescente organique (OLED1) ;
le dix-septième transistor (T17) est configuré pour piloter la deuxième diode électroluminescente organique (OLED2) ;
le seizième transistor (T16) est configuré pour compenser le dix-septième transistor (T17) ;
le quinzième transistor (T15) est configuré pour écrire des données dans le dix-septième transistor (T17) ;
le treizième transistor (T13) est configuré pour réinitialiser le dix-septième transistor (T17) ;
le deuxième condensateur de stockage (C2) est configuré pour stocker une tension de pilotage du dix-septième transistor (T17) ;
le dix-neuvième transistor (T19) est configuré pour initialiser la deuxième diode électroluminescente organique (OLED2) ;
le quatorzième transistor (T14) et le dix-huitième transistor (T18) sont configurés pour commander les opérations d'activation et de désactivation de la deuxième diode électroluminescente organique (OLED2) ;
le huitième transistor (T8) et le onzième transistor (T11) sont configurés pour commander les opérations d'activation et de désactivation de la troisième diode électroluminescente organique (OLED3) ;
le neuvième transistor (T9) et le dixième transistor (T10) sont configurés pour piloter la troisième diode électroluminescente organique (OLED3) ;
le douzième transistor (T12) est configuré pour initialiser la troisième diode électroluminescente organique (OLED3) ;
la première extrémité d'alimentation électrique (ELVDD) est configurée pour fournir une première tension lumineuse (Velvdd) pour la première diode électroluminescente organique (OLED1), la deuxième diode électroluminescente organique (OLED2) et la troisième diode électroluminescente organique (OLED3) ;
la deuxième extrémité d'alimentation électrique (ELVSS) est configurée pour fournir une seconde tension lumineuse (Velvss) pour la première diode électroluminescente organique (OLED1), la deuxième diode électroluminescente organique (OLED2) et la troisième diode électroluminescente organique (OLED3) ;
la troisième extrémité d'alimentation électrique (Vx) est configurée pour fournir une tension de réinitialisation pour le sixième transistor (T6) et le treizième transistor (T13) ;
la première extrémité de signal de données (Data1) est configurée pour fournir un premier signal de données ou un signal d'attente pour le premier transistor (T1) ;
la deuxième extrémité de signal de données (Data2) est configurée pour fournir un deuxième signal de données ou un signal d'attente pour le quinzième transistor (T15) ;
la première extrémité de commande (Sn-1) est configurée pour fournir un premier signal de commande pour commander les opérations d'activation et de désactivation du sixième transistor (T6) et du treizième transistor (T13) ;
la deuxième extrémité de commande (Sn) est configurée pour fournir un deuxième signal de commande pour commander les opérations d'activation et de désactivation du premier transistor (T1), du troisième transistor (T3), du quinzième transistor (T15) et du seizième transistor (T16) ;
la troisième extrémité de commande (Sn+1) est configurée pour fournir un troisième signal de commande pour commander les opérations d'activation et de désactivation du septième transistor (T7), du douzième transistor (T12) et du dix-neuvième transistor (T19) ; et
la quatrième extrémité de commande (En) est configurée pour fournir un quatrième signal de commande pour commander les opérations d'activation et de désactivation du deuxième transistor (T2), du cinquième transistor (T5), du huitième transistor (T8), du onzième transistor (T11), du quatorzième transistor (T14) et du dix-huitième transistor (T18) ;
une électrode de source du premier transistor (T1) est connectée électriquement à la première extrémité de signal de données (Data1) ;
une électrode de grille du premier transistor (T1), une électrode de grille du troisième transistor (T3), une électrode de grille du quinzième transistor (T15) et une électrode de grille du seizième transistor (T16) sont connectées électriquement à la deuxième extrémité de commande (Sn) ;
une électrode de grille du deuxième transistor (T2), une électrode de grille du cinquième transistor (T5), une électrode de grille du huitième transistor (T8), une électrode de grille du onzième transistor (T11), une électrode de grille du quatorzième transistor (T14) et une électrode de grille du dix-huitième transistor (T18) sont connectées électriquement à la quatrième extrémité de commande (En) ;
une électrode de source du deuxième transistor (T2), une première extrémité du premier condensateur de stockage (C1), une électrode de source du huitième transistor (T8), une électrode de source du quatorzième transistor (T14) et une première extrémité du deuxième condensateur de stockage (C2) sont connectées électriquement à la première extrémité d'alimentation électrique (ELVDD) ;
une électrode de drain du troisième transistor (T3) et une électrode de drain du sixième transistor (T6) sont connectées électriquement à un premier noeud (N1) ;
une électrode de drain du quatrième transistor (T4) est connectée électriquement à une électrode de source du cinquième transistor (T5) ;
une électrode de drain du cinquième transistor (T5) et une électrode de drain du septième transistor (T7) sont connectées électriquement à une première extrémité de la première diode électroluminescente organique (OLED1) ;
une électrode de source du sixième transistor (T6), une électrode de source du septième transistor (T7), une électrode de source du douzième transistor (T12), une électrode de drain du treizième transistor (T13) et une électrode de source du dix-neuvième transistor (T19) sont connectées électriquement à la troisième extrémité d'alimentation électrique (Vx) ;
une électrode de grille du sixième transistor (T6) et une électrode de grille du treizième transistor (T13) sont connectées électriquement à la première extrémité de commande (Sn-1) ;
une électrode de grille du septième transistor (T7), une électrode de grille du douzième transistor (T12) et une électrode de grille du dix-neuvième transistor (T19) sont connectées électriquement à la troisième extrémité de commande (Sn+1) ;
une électrode de drain du onzième transistor (T11) et une première extrémité de la troisième diode électroluminescente organique (OLED3) et une électrode de drain du douzième transistor (T12) sont connectées électriquement les unes aux autres ;
une électrode de source du treizième transistor (T13) et une électrode de drain du seizième transistor (T16) sont connectées électriquement à un deuxième noeud (N2) ;
une électrode de source du quinzième transistor (T15) est connectée électriquement à une deuxième extrémité de signal de données (Data2) ;
une électrode de drain du dix-septième transistor (T17) est connectée électriquement à une électrode de source du dix-huitième transistor (T18) ;
une électrode de drain du dix-huitième transistor (T18) et une électrode de drain du dix-neuvième transistor (T19) sont connectées électriquement à une première extrémité de la deuxième diode électroluminescente organique (OLED2) ; et
une seconde extrémité de la première diode électroluminescente organique (OLED1), une seconde extrémité de la deuxième diode électroluminescente organique (OLED2) et une seconde extrémité de la troisième diode électroluminescente organique (OLED3) sont connectées électriquement à la deuxième extrémité d'alimentation électrique (ELVSS) ;
**caractérisé en ce que** :
une électrode de drain du premier transistor (T1), une électrode de drain du deuxième transistor (T2), une électrode de source du troisième transistor (T3) et une électrode de source du quatrième transistor (T4) sont connectées électriquement les unes aux autres ;
une électrode de drain du huitième transistor (T8) est connectée électriquement à une électrode de source du neuvième transistor (T9) ;
une électrode de drain du neuvième transistor (T9) est connectée électriquement à une électrode de source du dixième transistor (T10) ;
une électrode de drain du dixième transistor (T10) est connectée électriquement à une électrode de source du onzième transistor (T11) ;
une électrode de drain du quatorzième transistor (T14), une électrode de drain du quinzième transistor (T15), une électrode de source du seizième transistor (T16) et une électrode de source du dix-septième transistor (T17) sont connectées électriquement les unes aux autres ;
une électrode de grille du quatrième transistor (T4), une seconde extrémité du premier condensateur de stockage (C1) et une électrode de grille du neuvième transistor (T9) sont directement connectées électriquement les unes aux autres ; et
une électrode de grille du dixième transistor (T10), une électrode de grille du dix-septième transistor (T17) et une seconde extrémité du deuxième condensateur de stockage (C2) sont directement connectées électriquement les unes aux autres.

2. Circuit de pixels (100) selon la revendication 1, dans lequel :
la première diode électroluminescente organique (OLED1) émet une lumière d'une première couleur lors du processus de travail ;
la deuxième diode électroluminescente organique (OLED2) émet une lumière d'une deuxième couleur lors du processus de travail ;
la troisième diode électroluminescente organique (OLED3) émet une lumière d'une troisième couleur lors du processus de travail ; et
une couleur mélangée de la lumière de la première couleur et de la lumière de la deuxième couleur est la troisième couleur.

3. Panneau d'affichage, comprenant le circuit de pixels (100) selon la revendication 1 ou 2.

4. Panneau d'affichage selon la revendication 3, comprenant en outre :
une quatrième diode électroluminescente organique (OLED4), un vingtième transistor (T20), un vingt et unième transistor (T21), un vingt-deuxième transistor (T22), un vingt-troisième transistor (T23), un vingt-quatrième transistor (T24), un vingt-cinquième transistor (T25), un vingt-sixième transistor (T26), un troisième condensateur de stockage (C3) et une troisième extrémité de signal de données (Data3) ;
dans lequel la quatrième diode électroluminescente organique (OLED4) est configurée pour émettre de la lumière lors du processus de travail ;
le vingt-troisième transistor (T23) est configuré pour piloter la quatrième diode électroluminescente organique (OLED4) ;
le vingt-deuxième transistor (T22) est configuré pour compenser le vingt-troisième transistor (T23) ;
le vingtième transistor (T20) est configuré pour écrire des données dans le vingt-troisième transistor (T23) ;
le vingt-cinquième transistor (T25) est configuré pour réinitialiser le vingt-troisième transistor (T23) ;
le troisième condensateur de stockage (C3) est configuré pour stocker une tension de pilotage du vingt-troisième transistor (T23) ;
le vingt-sixième transistor (T26) est configuré pour initialiser la quatrième diode électroluminescente organique (OLED4) ;
le vingt et unième transistor (T21) et le vingt-quatrième transistor (T24) sont configurés pour commander les opérations d'activation et de désactivation de la quatrième diode électroluminescente organique (OLED4) ;
la première extrémité d'alimentation électrique (ELVDD) est configurée pour fournir la première tension lumineuse (Velvdd) pour la quatrième diode électroluminescente organique (OLED4) ;
la deuxième extrémité d'alimentation électrique (ELVSS) est configurée pour fournir la seconde tension lumineuse (Velvss) pour la quatrième diode électroluminescente organique (OLED4) ;
la troisième extrémité d'alimentation électrique (Vx) est configurée pour fournir la tension de réinitialisation pour le vingt-cinquième transistor (T25) ;
la troisième extrémité de signal de données (Data3) est configurée pour fournir un troisième signal de données ou un signal d'attente pour le vingtième transistor (T20) ;
la première extrémité de commande (Sn-1) est configurée pour fournir le premier signal de commande pour commander les opérations d'activation et de désactivation du vingt-cinquième transistor (T25) ;
la deuxième extrémité de commande (Sn) est configurée pour fournir le deuxième signal de commande pour commander les opérations d'activation et de désactivation du vingtième transistor (T20) et du vingt-deuxième transistor (T22) ;
la troisième extrémité de commande (Sn+1) est configurée pour fournir le troisième signal de commande pour commander les opérations d'activation et de désactivation du vingt-sixième transistor (T26) ; et
la quatrième extrémité de commande (En) est configurée pour fournir le quatrième signal de commande pour commander les opérations d'activation et de désactivation du vingt et unième transistor (T21) et du vingt-quatrième transistor (T24) ;
une électrode de source du vingtième transistor (T20) est connectée électriquement à la troisième extrémité de signal de données (Data3) ;
une électrode de grille du vingtième transistor (T20) et une électrode de grille du vingt-deuxième transistor (T22) sont connectées électriquement à la deuxième extrémité de commande (Sn) ;
une électrode de drain du vingtième transistor (T20), une électrode de drain du vingt et unième transistor (T21), une électrode de source du vingt-deuxième transistor (T22) et une électrode de source du vingt-troisième transistor (T23) sont connectées électriquement les unes aux autres ;
une électrode de grille du vingt et unième transistor (T21) et une électrode de grille du vingt-quatrième transistor (T24) sont connectées électriquement à la quatrième extrémité de commande (En) ;
une électrode de source du vingt et unième transistor (T21) et une première extrémité du troisième condensateur de stockage (C3) sont connectées électriquement à la première extrémité d'alimentation électrique (ELVDD) ;
une électrode de drain du vingt-deuxième transistor (T22), une électrode de grille du vingt-troisième transistor (T23), une électrode de drain du vingt-cinquième transistor (T25) et une seconde extrémité du troisième condensateur de stockage (C3) sont connectées électriquement à un troisième noeud (N3) ;
une électrode de drain du vingt-troisième transistor (T23) est connectée électriquement à une électrode de source du vingt-quatrième transistor (T24) ;
une électrode de drain du vingt-quatrième transistor (T24) et une électrode de drain du vingt-sixième transistor (T26) sont connectées électriquement à une première extrémité de la quatrième diode électroluminescente organique (OLED4) ;
une électrode de source du vingt-cinquième transistor (T25) et une électrode de source du vingt-sixième transistor (T26) sont connectées électriquement à la troisième extrémité d'alimentation électrique (Vx) ;
une électrode de grille du vingt-cinquième transistor (T25) est connectée électriquement à la première extrémité de commande (Sn-1) ;
une électrode de grille du vingt-sixième transistor (T26) est connectée électriquement à la troisième extrémité de commande (Sn+1) ; et
une seconde extrémité de la quatrième diode électroluminescente organique (OLED4) est connectée électriquement à la deuxième extrémité d'alimentation électrique (ELVSS) ;
dans lequel la première diode électroluminescente organique (OLED1) émet une lumière rouge, la deuxième diode électroluminescente organique (OLED2) émet une lumière verte, la troisième diode électroluminescente organique (OLED3) émet une lumière jaune et la quatrième diode électroluminescente organique (OLED4) émet une lumière bleue.

5. Procédé de pilotage appliqué au pilotage du circuit de pixels (100) selon la revendication 1 ou 2, comprenant : une période de réinitialisation (t2), une période de compensation (t3), une période d'initialisation (t4) et une période d'émission (t6) ; dans lequel :
dans la période de réinitialisation (t2) :
la première extrémité de commande (Sn-1) émet en sortie un signal actif ;
la deuxième extrémité de commande (Sn) émet en sortie un signal inactif ;
la troisième extrémité de commande (Sn+1) émet en sortie un signal inactif ;
la quatrième extrémité de commande (En) émet en sortie un signal inactif ; et
la première extrémité de signal de données (Data1) émet en sortie un signal d'attente ; la deuxième extrémité de signal de données (Data2) émet en sortie un signal d'attente ;
dans la période de compensation (t3) :
la première extrémité de commande (Sn-1) émet en sortie un signal inactif ;
la deuxième extrémité de commande (Sn) émet en sortie un signal actif ;
la troisième extrémité de commande (Sn+1) émet en sortie un signal inactif ;
la quatrième extrémité de commande (En) émet en sortie un signal inactif ; et
la première extrémité de signal de données (Data1) émet en sortie un premier signal de données et la deuxième extrémité de signal de données (Data2) émet en sortie un signal d'attente ; ou la première extrémité de signal de données (Data1) émet en sortie un signal d'attente et la deuxième extrémité de signal de données (Data2) émet en sortie un deuxième signal de données ; ou la première extrémité de signal de données (Data1) émet en sortie le premier signal de données et la deuxième extrémité de signal de données (Data2) émet en sortie le deuxième signal de données ;
dans la période d'initialisation (t4) :
la première extrémité de commande (Sn-1) émet en sortie un signal inactif ;
la deuxième extrémité de commande (Sn) émet en sortie un signal inactif ;
la troisième extrémité de commande (Sn+1) émet en sortie un signal actif ;
la quatrième extrémité de commande (En) émet en sortie un signal inactif ;
la première extrémité de signal de données (Data1) émet en sortie un signal d'attente ; et
la deuxième extrémité de signal de données (Data2) émet en sortie un signal d'attente ; et
dans la période d'émission (t6) :
la première extrémité de commande (Sn-1) émet en sortie un signal inactif ;
la deuxième extrémité de commande (Sn) émet en sortie un signal inactif ;
la troisième extrémité de commande (Sn+1) émet en sortie un signal inactif ;
la quatrième extrémité de commande (En) émet en sortie un signal actif ;
la première extrémité de signal de données (Data1) émet en sortie un signal d'attente ; et
la deuxième extrémité de signal de données (Data2) émet en sortie un signal d'attente.

6. Procédé de pilotage selon la revendication 5, comprenant en outre : une période de pré-réinitialisation (t1) et une période de pré-émission (t5), dans lequel la période de pré-réinitialisation (t1) est après la période d'émission (t6) et avant la période de réinitialisation (t2) ; la période de pré-émission (t5) est après la période d'initialisation (t4) et avant la période d'émission (t6) ;
dans la période de pré-réinitialisation (t1) :
la première extrémité de commande (Sn-1) émet en sortie un signal inactif ;
la deuxième extrémité de commande (Sn) émet en sortie un signal inactif ;
la troisième extrémité de commande (Sn+1) émet en sortie un signal inactif ;
la quatrième extrémité de commande (En) émet en sortie un signal inactif ;
la première extrémité de signal de données (Data1) émet en sortie un signal d'attente ; et
la deuxième extrémité de signal de données (Data2) émet en sortie un signal d'attente ; et
dans la période de pré-émission (t5) :
la première extrémité de commande (Sn-1) émet en sortie un signal inactif ;
la deuxième extrémité de commande (Sn) émet en sortie un signal inactif ;
la troisième extrémité de commande (Sn+1) émet en sortie un signal inactif ;
la quatrième extrémité de commande (En) émet en sortie un signal inactif ;
la première extrémité de signal de données (Data1) émet en sortie un signal d'attente ; et
la deuxième extrémité de signal de données (Data2) émet en sortie un signal d'attente.

7. Procédé de pilotage selon la revendication 5, dans lequel, dans la période de compensation (t3) :
lorsque la première extrémité de signal de données (Data1) émet en sortie le premier signal de données et que la deuxième extrémité de signal de données (Data2) émet en sortie le signal d'attente, la première diode électroluminescente organique (OLED1) émet en sortie de la lumière de manière indépendante, et le premier signal de données est configuré pour commander une luminosité de la première diode électroluminescente organique (OLED1) ;
lorsque la première extrémité de signal de données (Data1) émet en sortie le signal d'attente et que la deuxième extrémité de signal de données (Data2) émet en sortie le deuxième signal de données, la deuxième diode électroluminescente organique (OLED2) émet en sortie de la lumière de manière indépendante, et le deuxième signal de données est configuré pour commander une luminosité de la deuxième diode électroluminescente organique (OLED2) ; et
lorsque la première extrémité de signal de données (Data1) émet en sortie le premier signal de données et que la deuxième extrémité de signal de données (Data2) émet en sortie le deuxième signal de données, la première diode électroluminescente organique (OLED1), la deuxième diode électroluminescente organique (OLED2) et la troisième diode électroluminescente organique (OLED3) émettent de la lumière de manière simultanée ; le premier signal de données est configuré pour commander la luminosité de la première diode électroluminescente organique (OLED1) ; le deuxième signal de données est configuré pour commander la luminosité de la deuxième diode électroluminescente organique (OLED2) ; et dans le cas dans lequel une tension de sortie du premier signal de données (Vdata1) est inférieure à une tension de sortie du deuxième signal de données (Vdata2), le premier signal de données est utilisé pour commander la luminosité de la troisième diode électroluminescente organique (OLED3) et dans le cas dans lequel une tension de sortie du deuxième signal de données (Vdata2) est inférieure à une tension de sortie du premier signal de données (Vdata1), le deuxième signal de données est utilisé pour commander la luminosité de la troisième diode électroluminescente organique (OLED3).
